# EUROPEAN PATENT APPLICATION

(11) **EP 4 542 630 A1**
(43) Date of publication of application: **23.04.2025**
(21) Application number: 23827058.1
(22) Date of filing: 13.06.2023
(51) Int. Cl.: H01L 21/56, H01L 23/12

(54) **REMOVER COMPOSITION FOR LIGHT IRRADIATION REMOVAL**

(30) Priority: 20.06.2022 JP 2022098719
(71) Applicant: Nissan Chemical Corporation, Tokyo 103-6119 (JP)
(72) Inventor: OKUNO Takahisa, Toyama-shi, Toyama 939-2792 (JP); SHINJO Tetsuya, Toyama-shi, Toyama 939-2792 (JP)
(74) Representative: Hoffmann Eitle
(86) International application number: PCT/JP2023/021910
(87) International publication number: WO 2023/248872

(57) **Abstract**

There is provided a release agent composition containing an aqueous solvent, that is, a release agent composition for forming a release agent layer that can be released by light irradiation and is used for a laminate, in the laminate in which a support substrate and a semiconductor substrate or an electronic device layer can be firmly adhered to each other during processing of the semiconductor substrate or the electronic device layer, and the support substrate and the semiconductor substrate or the electronic device layer can be easily separated from each other by light irradiation after the substrate processing.

There is provided a release agent composition for light irradiation release for forming a release agent layer of a laminate which includes a semiconductor substrate or an electronic device layer, a light-transmissive support substrate, and a release agent layer provided between the semiconductor substrate or the electronic device layer and the support substrate, in which the electronic device layer includes a plurality of semiconductor chip substrates and a sealing resin disposed between the semiconductor chip substrates, and which is used for releasing the semiconductor substrate or the electronic device layer from the support substrate after the release agent layer absorbs light irradiated from the support substrate side, in which the release agent composition contains a light-absorbing compound that contributes to making the semiconductor substrate or the electronic device layer and the support substrate easily released by absorbing the light, and a solvent, and the solvent contains water.

## Description

### Technical Field

The present invention relates to a release agent composition for light irradiation release.

### Background Art

Conventionally, a semiconductor wafer that has been integrated in a two-dimensional planar direction is required to have a semiconductor integration technology in which a planar surface is further integrated (stacked) in a three-dimensional direction for the purpose of further integration. This three-dimensional stacking is a technology that integrates multiple layers while connecting multiple layers through through silicon vias (TSV). When integrating multiple layers, each wafer to be integrated is thinned by polishing on the side opposite to the formed circuit surface (that is, the back surface), and the thinned semiconductor wafers are stacked.

A semiconductor wafer before thinning (also referred to herein simply as a wafer) is adhered to a support for polishing with a polishing device. The adhesion at that time is referred to as temporary adhesion because the adhesion must be easily released after polishing. This temporary adhesion must be easily removed from the support, and when a large force is applied to the removal, the thinned semiconductor wafer may be cut or deformed, and is easily removed such that such a situation does not occur. However, at the time of polishing the back surface of the semiconductor wafer, it is not preferable for the semiconductor wafer to become detached or displaced due to polishing stress. Therefore, the performance required for temporary adhesion is to withstand the stress during polishing and to be easily removed after polishing.

For example, there is a demand for performance having a high stress (strong adhesive force) in the planar direction at the time of polishing and a low stress (weak adhesive force) in the longitudinal direction at the time of removal.

Although a method by laser irradiation has been disclosed (refer to, for example, Patent Literatures 1 and 2) for such an adhesion and separation process, a new technology related to release by irradiation of light such as laser is always required with further progress in the recent semiconductor field.

In addition, in the method of processing a substrate by temporarily adhering a support, examples of the substrate to be temporarily adhered include an electronic device layer including a plurality of semiconductor chip substrates and a sealing resin disposed between the semiconductor chip substrates, in addition to the semiconductor substrate intended for thinning as described above.

A semiconductor package (electronic component) including a semiconductor element (also referred to as a semiconductor chip substrate) has various forms depending on a compatible size, and examples thereof include a wafer level package (WLP) and a panel level I package (PLP).

In order to reduce the size of the semiconductor package, it is important to reduce the thickness of the substrate in the element to be incorporated. However, when the thickness of the substrate is reduced, the strength thereof is reduced, and the substrate is likely to be damaged during the semiconductor package production. On the other hand, a technology is known in which a substrate is temporarily adhered to a support using an adhesive, the substrate is processed, and then the substrate and the support are separated from each other (refer to, for example, Patent Literatures 3 and 4).

### Citation List

### Patent Literature

Patent Literature 1: JP 2004-64040 A
Patent Literature 2: JP 2012-106486 A
Patent Literature 3: JP 2019-34541 A
Patent Literature 4: JP 2020-107649 A

### Summary of Invention

### Technical Problem

Patent Literatures 1 and 2 describe a laminate in which two layers of a bonding layer (adhesion layer) and a light conversion layer (also referred to as a separation layer) containing a light absorber are stacked between a semiconductor substrate and a support in order to release the semiconductor substrate, which corresponds to the semiconductor wafer, and the support by laser irradiation.

In addition, Patent Literatures 3 and 4 describe a laminate in which two layers of an adhesive layer (adhesion layer) and a separation layer are stacked between an electronic device layer and a support in order to release the electronic device layer, which has a plurality of semiconductor chip substrates disposed in a sealing resin layer, and the support from each other by laser irradiation.

Incidentally, the separation layer described in Patent Literatures 1 to 4 is formed of a composition containing an organic solvent, but it is desired to reduce the use amount of the organic solvent as much as possible due to the problems of the working environment, the handling safety of the composition, waste liquid treatment, and the like. It is preferable that the separation layer can be formed from a composition containing an aqueous solvent instead of an organic solvent from the viewpoint of safety and environmental load reduction.

In order to make further progress in the recent semiconductor field, a new type of release agent composition to be used is always required to be developed.

Therefore, the present invention has been made in view of the above circumstances, and an object of the present invention is to provide a release agent composition containing an aqueous solvent, that is, a release agent composition for forming a release agent layer that can be released by light irradiation and is used for a laminate, in the laminate in which a support substrate and a semiconductor substrate or an electronic device layer can be firmly adhered to each other during processing of the semiconductor substrate or the electronic device layer, and the support substrate and the semiconductor substrate or the electronic device layer can be easily separated from each other by light irradiation after the substrate processing.

### Solution to Problem

As a result of intensive studies to solve the above problems, the present inventors have found that the above problems can be solved, and have completed the present invention having the following gist.

That is, the present invention includes the following.
[1] A release agent composition for light irradiation release for forming a release agent layer of a laminate which includes
   a semiconductor substrate or an electronic device layer,
   a light-transmissive support substrate, and
   a release agent layer provided between the semiconductor substrate or the electronic device layer and the support substrate,
   in which the electronic device layer includes a plurality of semiconductor chip substrates and a sealing resin disposed between the semiconductor chip substrates, and
   which is used for releasing the semiconductor substrate or the electronic device layer from the support substrate after the release agent layer absorbs light irradiated from the support substrate side, in which
   the release agent composition contains a light-absorbing compound that contributes to making the semiconductor substrate or the electronic device layer and the support substrate easily released by absorbing the light, and a solvent, and
   the solvent contains water.
[2] The release agent composition according to [1], in which a content of the water is 50% by mass or more with respect to the solvent in the release agent composition.
[3] The release agent composition according to [2], in which a content of the water is 98% by mass or more with respect to the solvent in the release agent composition.
[4] The release agent composition according to [1], in which when an absorption spectrum of the light-absorbing compound is measured in a range of 250 nm to 800 nm, the absorption spectrum of the light-absorbing compound has a maximum absorbance between 250 nm and 350 nm, the highest value being within a range of 250 nm to 800 nm.
[5] The release agent composition according to [4], in which the light-absorbing compound is a polyphenol-based compound.
[6] The release agent composition according to [5], in which the polyphenol-based compound is a compound selected from a group consisting of condensed tannin obtained by polymerizing a compound having a flavanol skeleton, hydrolyzable tannin obtained by ester-bonding an aromatic compound of gallic acid or ellagic acid to a sugar, and a flavonoid derived from a compound having a flavanone skeleton structure.
[7] The release agent composition according to [6], in which the hydrolyzable tannin is tannic acid represented by the following Formula (9): 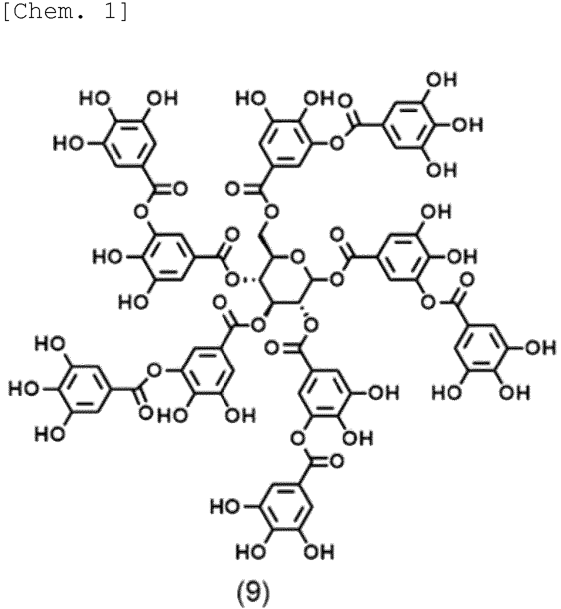
[8] The release agent composition according to any one of [1] to [7], in which the release agent composition further contains a water-soluble dye.

### Advantageous Effects of Invention

According to the present invention, it is possible to provide a release agent composition containing an aqueous solvent, that is, a release agent composition for forming a release agent layer that can be released by light irradiation and is used for a laminate, in the laminate in which a support substrate and a semiconductor substrate or an electronic device layer can be firmly adhered to each other during processing of the semiconductor substrate or the electronic device layer, and the support substrate and the semiconductor substrate or the electronic device layer can be easily separated from each other by light irradiation after the substrate processing.

### Brief Description of Drawings

Fig. 1 is a schematic cross-sectional view of an example of a laminate in a first embodiment.
Fig. 2 is a schematic cross-sectional view of another example of the laminate in the first embodiment.
Fig. 3 is a schematic cross-sectional view of an example of a laminate in a second embodiment.
Fig. 4 is a schematic cross-sectional view of another example of the laminate in the second embodiment.
Fig. 5 is a schematic cross-sectional view for explaining a method for producing a laminate showing an example in the second embodiment.
Fig. 6 is a schematic cross-sectional view for explaining a method for producing the laminate showing an example in the second embodiment.
Fig. 7 is a schematic cross-sectional view for explaining a method for producing the laminate showing an example in the second embodiment.
Fig. 8 is a schematic cross-sectional view for explaining a method for producing the laminate showing an example in the second embodiment.
Fig. 9 is a schematic cross-sectional view for explaining a method for processing the laminate showing an example in the second embodiment.
Fig. 10 is a schematic cross-sectional view for explaining a method for processing the laminate showing an example in the second embodiment.
Fig. 11 is a schematic cross-sectional view for explaining a method for separating the laminate showing an example in the second embodiment.
Fig. 12 is a schematic cross-sectional view for explaining a method for separating the laminate showing an example in the second embodiment.
Fig. 13 is a schematic cross-sectional view for explaining a method for cleaning the laminate showing an example in the second embodiment after the separation.

### Description of Embodiments

### (Release Agent Composition for Light Irradiation Release)

A release agent composition of the present invention is a composition that can be released by light irradiation.

The release agent composition of the present invention is a composition used for easily releasing a semiconductor substrate or an electronic device layer from a support substrate.

The release agent composition of the present invention contains a light-absorbing compound that contributes to making the semiconductor substrate or the electronic device layer and the support substrate easily released by absorbing light, and a solvent containing water.

The release agent composition of the present invention may further contain a water-soluble dye in addition to the light-absorbing compound and the solvent containing the water.

In addition, the release agent composition of the present invention may contain other components in addition to the light-absorbing compound, the solvent containing water, and the water-soluble dye.

### <Solvent>

The solvent contained in the release agent composition of the present invention contains water.

Conventionally, an organic solvent has been contained in a release agent composition, but in the present invention, by using water as a solvent, safety for the environment and human body can be secured, the waste liquid treatment cost can be reduced, and the environmental load can be reduced.

In the present invention, the content of water is preferably 50% by mass or more, more preferably 98% by mass or more, and particularly preferably 100% by mass with respect to the solvent in the release agent composition.

### <Light-absorbing Compound>

In the release agent composition according to the present invention, it is preferable that when an absorption spectrum of the light-absorbing compound is measured in a range of 250 nm to 800 nm, the absorption spectrum of the light-absorbing compound have a maximum absorbance between 250 nm and 350 nm, the highest value being within a range of 250 nm to 800 nm. The absorption spectrum may have, for example, a maximum value, the highest value between 260 nm and 315 nm. By having such light absorption characteristics, good releasability between the semiconductor substrate or the electronic device layer and the support substrate can be realized.

The absorption spectrum can be measured using a spectrophotometer (for example, an ultraviolet-visible near-infrared (UV-Vis-NIR) spectrophotometer).

The measurement range may exceed 250nm to 800nm, as long as the measurement range includes this range.

In the measurement of the absorption spectrum, it is preferable to form a film having such a thickness that the presence of a maximum value can be determined as a measurement sample. For example, the thickness of the film of the measurement sample is about 200 nm.

The light-absorbing compound is preferably a polyphenol-based compound.

It is preferable that the polyphenol-based compound be a compound selected from a group consisting of condensed tannin obtained by polymerizing a compound having a flavanol skeleton, hydrolyzable tannin obtained by ester-bonding an aromatic compound of gallic acid or ellagic acid to a sugar, and a flavonoid derived from a compound having a flavanone skeleton structure.

The polyphenol-based compound according to the present invention represents a plant component having a plurality of phenolic hydroxy groups (hydroxy groups bonded to an aromatic ring such as a benzene ring or a naphthalene ring) in the molecule.

The polyphenol-based compound according to the present invention includes tannin and flavonoid.

The tannin according to the present invention refers to a water-soluble compound that is derived from plants, reacts with proteins, alkaloids, and metal ions, and is strongly bonded to form a poorly soluble salt. Such tannin is an aromatic compound which is universally present in the plant kingdom and has many phenolic hydroxy groups.

The tannin according to the present invention includes condensed tannin and hydrolyzable tannin.

The condensed tannin according to the present invention is a compound obtained by polymerizing a compound having a flavanol skeleton represented by the following Formula (p).

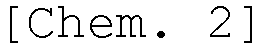

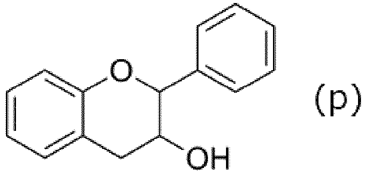

The hydrolyzable tannin according to the present invention is a compound obtained by ester bonding between an aromatic compound of gallic acid or ellagic acid represented by the following Formula (q) and a sugar such as glucose represented by the following Formula (r).

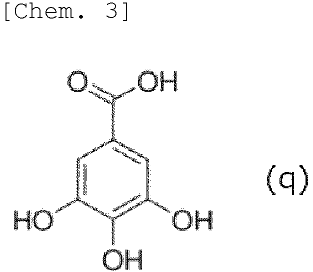

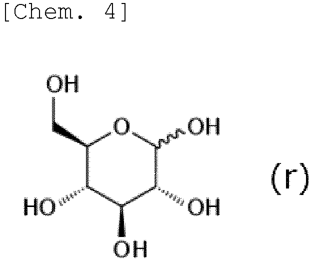

As a preferred embodiment of the hydrolyzable tannin, a tannic acid represented by the following Formula (9) can be mentioned.

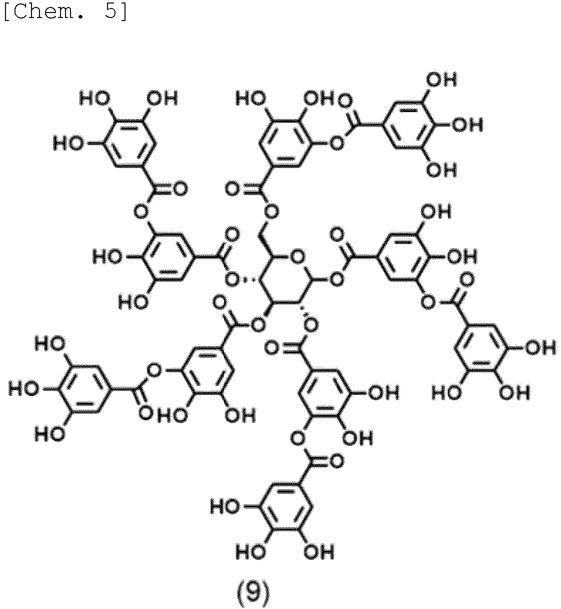

The flavonoid according to the present invention represents a compound biosynthesized by various modifications of flavanone, which is a kind of flavonoid, and for example, represents a compound derived from a compound having a flavanone skeleton structure represented by the following Formula (s).

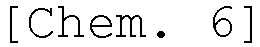

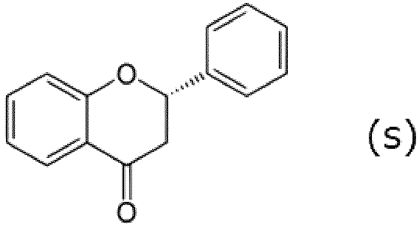

Preferred embodiments of the flavonoid include flavonoids represented by the following Formula (10) or Formula (11).

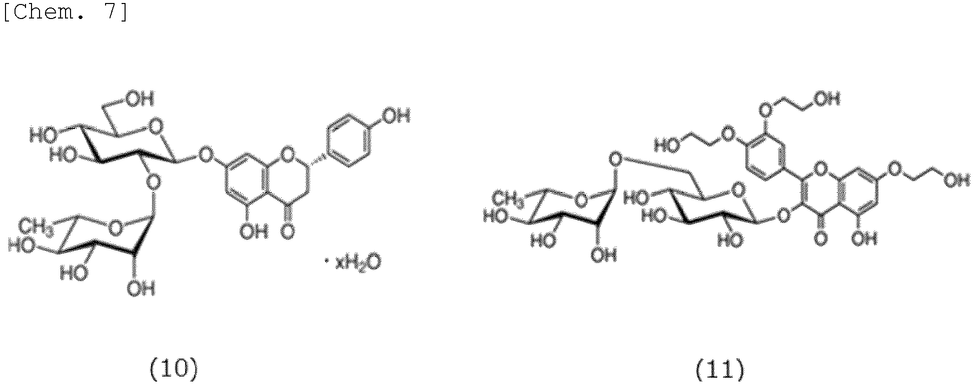

### <Water-soluble Dye>

The release agent composition of the present invention can further contain a water-soluble dye.

In the present invention, since water is used as the solvent, various water-soluble dyes can be mixed in the release agent composition. For example, a water-soluble dye exhibiting absorption in a wavelength range different from the light absorption wavelength range exhibited by the light-absorbing compound can be contained in the release agent composition. Thereby, the light absorption wavelength region of the release agent composition can be widened, and the wavelength selectivity of the laser irradiation light can be widened.

The water-soluble dye according to the present invention is not particularly limited as long as the water-soluble dye is soluble in water, and can be appropriately used according to the purpose, but for example, water-soluble dyes represented by the following formulas (a) to (d) are preferably used.

As the water-soluble dye represented by the Formula (a), for example, Chlorantine Fast Red 5B (manufactured by Tokyo Chemical Industry Co., Ltd.) can be used, as the water-soluble dye represented by the Formula (b), for example, Chrome Pure Blue BX (manufactured by Tokyo Chemical Industry Co., Ltd.) can be used, and as the water-soluble dye represented by the Formula (d), for example, Acid Red 18 (manufactured by Tokyo Chemical Industry Co., Ltd.) can be used.

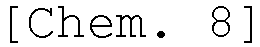

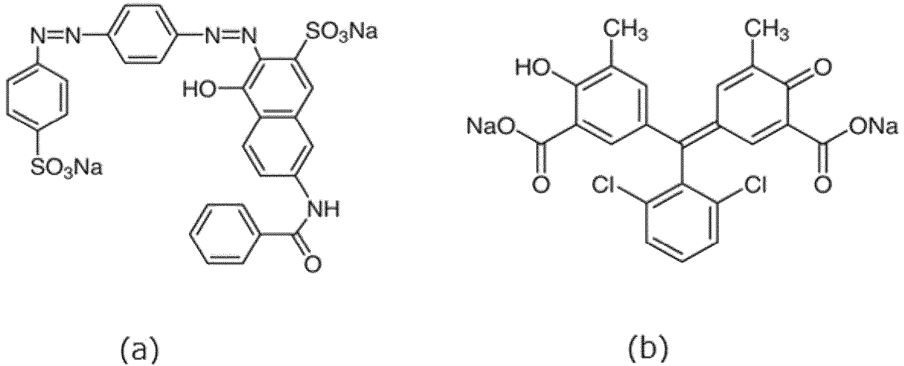

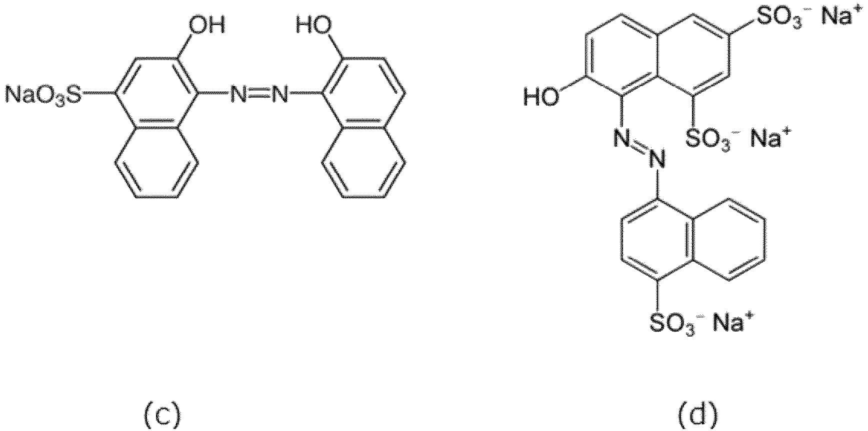

### <Other Components>

The release agent composition of the present invention can contain an organic solvent other than water as a solvent as long as the effect of the present invention is not impaired, but in the present invention, it is preferable that the organic solvent is not contained as much as possible.

Specific examples of the organic solvent include, but are not limited to, aliphatic hydrocarbons, aromatic hydrocarbons, and ketones.

More specific examples of the organic solvent include, but are not limited to, hexane, heptane, octane, nonane, decane, undecane, dodecane, isododecane, menthane, limonene, toluene, xylene, mesitylene, cumene, methyl isobutyl ketone (MIBK), butyl acetate, diisobutyl ketone, 2-octanone, 2-nonanone, and 5-nonanone.

Specifically, examples thereof include ethylene glycol monomethyl ether, ethylene glycol monoethyl ether, methyl cellosolve acetate, ethyl cellosolve acetate, diethylene glycol monomethyl ether, diethylene glycol monoethyl ether, propylene glycol, propylene glycol monomethyl ether (PGME), propylene glycol monomethyl ether acetate (PGMEA), propylene glycol monoethyl ether, propylene glycol monoethyl ether acetate, propylene glycol propyl ether acetate, toluene, xylene, methyl ethyl ketone, cyclopentanone, cyclohexanone, ethyl 2-hydroxypropionate, ethyl 2-hydroxy-2-methylpropionate, ethyl ethoxyacetate, ethyl hydroxyacetate, methyl 2-hydroxy-3-methylbutanoate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, ethyl lactate, and butyl lactate.

### <<Preparation of Release Agent Composition>>

The release agent composition of the present invention can be prepared by mixing the light-absorbing compound with the solvent containing water.

The blending ratio of the light-absorbing compound and the solvent containing water is not particularly limited as long as the effect of the present invention is exhibited, and can be appropriately selected according to the object, but for example, in terms of a mass ratio, the light-absorbing compound:solvent is preferably at a ratio of 0.1:9.9 to 5:5, and more preferably at a ratio of 0.5:9.5 to 3:7.

The release agent composition of the present invention can be prepared by mixing the light-absorbing compound, the solvent containing water, and the water-soluble dye with each other.

The blending ratio of the light-absorbing compound, the solvent containing water, and the water-soluble dye is not particularly limited as long as the effect of the present invention is exhibited, and can be appropriately selected according to the purpose. For example, in terms of a mass ratio, the light-absorbing compound:solvent:water-soluble dye is preferably at a ratio of 0.1 to 5:0.1 to 5:9.8 to 5, and more preferably at a ratio of 0.5 to 3:0.5 to 3:4 to 9.

### (Laminate)

The laminate according to the present invention includes a semiconductor substrate or an electronic device layer, a support substrate, and a release agent layer for light irradiation release.

The laminate according to the present invention preferably further includes an adhesive layer, and includes a semiconductor substrate or an electronic device layer, a support substrate, a release agent layer for light irradiation release, and an adhesion layer.

When the release agent layer according to the present invention is formed to have not only a release function of releasing the semiconductor substrate or the electronic device layer from the support substrate by light irradiation but also an adhesion function of adhering the semiconductor substrate or the electronic device layer to the support substrate (that **is,** when the release agent layer is formed using a release agent composition containing a component that exhibits both functions), the laminate may be formed not in a two-layer structure of the release agent layer and the adhesion layer but in a one-layer structure of the release agent layer having adhesive performance.

The support substrate has light transmissivity.

The release agent layer for light irradiation release is provided between the semiconductor substrate or the electronic device layer and the support substrate.

The laminate is used for releasing the semiconductor substrate or the electronic device layer from the support substrate after the release agent layer absorbs light irradiated from the support substrate side.

The release agent layer for light irradiation release is a layer formed of the release agent composition for light irradiation release of the present invention described above.

The laminate of the present invention is used for temporary adhesion for processing a semiconductor substrate or an electronic device layer, and can be suitably used for processing such as thinning of the semiconductor substrate or the electronic device layer.

While the semiconductor substrate is subjected to processing such as thinning, the semiconductor substrate is supported on the support substrate via the adhesion layer. On the other hand, after the processing of the semiconductor substrate, the release agent layer is irradiated with light, and thereafter, the support substrate and the semiconductor substrate are separated from each other. Due to the specific light-absorbing compound contained in the release agent composition, in the release agent layer formed from the release agent composition, the specific light-absorbing compound absorbs light (for example, laser light) to alter (for example, separation or decomposition) the release agent layer. As a result, after the release agent layer is irradiated with light, the semiconductor substrate and the support substrate are easily released.

In addition, while the electronic device layer is subjected to processing such as thinning, the electronic device layer is supported on the support substrate via the adhesion layer. On the other hand, after the processing of the electronic device layer, the release agent layer is irradiated with light, and thereafter, the support substrate and the electronic device layer are separated from each other.

With the release agent layer according to the present invention, the semiconductor substrate or the electronic device layer and the support substrate are easily released after the release agent layer is irradiated with light. Furthermore, residues of the release agent layer or the adhesion layer remaining on the semiconductor substrate, the electronic device layer, or the support substrate after the semiconductor substrate or the electronic device layer and the support substrate are released can be removed by, for example, a cleaning agent composition for cleaning the semiconductor substrate or the like.

The wavelength of light used for releasing is preferably, for example, a wavelength of 250 to 600 nm, and more preferably a wavelength of 250 to 370 nm. A more suitable wavelength is 308 nm, 343 nm, 355 nm, 365 nm, or 532 nm. The irradiation amount of light required for release is an irradiation amount that can cause suitable alteration, for example, decomposition of a specific light-absorbing compound.

The light used for release may be laser light or non-laser light emitted from a light source such as an ultraviolet lamp.

Hereinafter, the case where the laminate has a semiconductor substrate and the case where the laminate has an electronic device layer will be described in detail separately.

The case where the laminate has a semiconductor substrate will be described in the following <First Embodiment>, and the case where the laminate has an electronic device layer will be described in the following

### <Second Embodiment>.

### <First Embodiment>

A laminate having a semiconductor substrate is used for processing a semiconductor substrate. While the semiconductor substrate is processed, the semiconductor substrate is adhered to the support substrate via the adhesion layer. After processing the semiconductor substrate, the release agent layer is irradiated with light, and then the semiconductor substrate is separated from the support substrate.

### <<Semiconductor Substrate>>

The main material constituting the entire semiconductor substrate is not particularly limited as long as the material is used for this type of application, and examples thereof include silicon, silicon carbide, and a compound semiconductor.

The shape of the semiconductor substrate is not particularly limited, and is, for example, a disk shape. Note that the disk-shaped semiconductor substrate does not need to have a completely circular surface, and for example, the outer periphery of the semiconductor substrate may have a straight portion called an orientation flat or may have a cut called a notch.

The thickness of the disk-shaped semiconductor substrate may be appropriately determined according to the purpose of use of the semiconductor substrate and the like, and is not particularly limited, but is, for example, 500 to 1,000 µm.

The diameter of the disk-shaped semiconductor substrate may be appropriately determined according to the purpose of use of the semiconductor substrate and the like, and is not particularly limited, but is, for example, 100 to 1,000 mm.

The semiconductor substrate may have a bump. The bump is a protruding terminal.

In the laminate, when the semiconductor substrate has a bump, the semiconductor substrate has a bump on the support substrate side.

In a semiconductor substrate, a bump is usually formed on a surface on which a circuit is formed. The circuit may be a single layer or a multilayer. The shape of the circuit is not particularly limited.

In the semiconductor substrate, a surface (back surface) opposite to the surface having the bump is a surface to be used for processing.

The material, size, shape, structure, and density of the bump of the semiconductor substrate are not particularly limited.

Examples of the bump include a ball bump, a print bump, a stud bump, and a plating bump.

Usually, the height, radius, and pitch of the bump are appropriately determined from the conditions of a bump height of about 1 to 200 µm, a bump radius of 1 to 200 µm, and a bump pitch of 1 to 500 µm.

Examples of the material of the bump include low melting point solder, high melting point solder, tin, indium, gold, silver, and copper. The bump may be composed of only a single component or may be composed of a plurality of components. More specific examples thereof include alloy plating mainly containing Sn, such as SnAg bumps, SnBi bumps, Sn bumps, and AuSn bumps.

In addition, the bump may have a stacked structure including a metal layer including at least one of these components.

An example of the semiconductor substrate is a silicon wafer having a diameter of about 300 mm and a thickness of about 770 µm.

### <<Support Substrate>>

The support substrate is not particularly limited as long as the support substrate is a member that is light transmissive to light applied to the adhesion layer and can support the semiconductor substrate when the semiconductor substrate is processed, and examples thereof include a glass support substrate.

The shape of the support substrate is not particularly limited, and examples thereof include a disk shape.

The thickness of the disk-shaped support substrate may be appropriately determined according to the size of the semiconductor substrate and the like, and is not particularly limited, but is, for example, 500 to 1,000 µm.

The diameter of the disk-shaped support substrate may be appropriately determined according to the size of the semiconductor substrate and the like, and is not particularly limited, but is, for example, 100 to 1,000 mm.

An example of the support substrate is a glass wafer having a diameter of about 300 mm and a thickness of about 700 µm.

### <<Release Agent Layer>>

The release agent layer is a layer formed of a release agent composition.

The release agent layer is provided between the semiconductor substrate and the support substrate.

The release agent layer may be in contact with the support substrate or may be in contact with the semiconductor substrate.

The release agent layer is formed using the release agent composition for light irradiation release of the present invention described above.

The release agent composition of the present invention can be suitably used for forming a release agent layer of a laminate including a semiconductor substrate, a support substrate, and a release agent layer provided between the semiconductor substrate and the support substrate. The laminate is used for releasing the semiconductor substrate and the support substrate after the release agent layer absorbs light irradiated from the support substrate side.

One of the characteristics of the release agent layer obtained from the release agent composition of the present invention is that the semiconductor substrate and the support substrate can be easily released after light irradiation.

In forming the release agent layer from the release agent composition, as long as the effect of the present invention is obtained, the specific light-absorbing compound may be crosslinked by itself or react with other components to form a crosslinked structure, or may maintain the structure without crosslinking or reacting.

In other words, in the release agent layer, the specific light-absorbing compound may be crosslinked by itself or react with other components to form a crosslinked structure, or may exist while maintaining the structure.

The thickness of the release agent layer is not particularly limited, but is usually 0.01 to 10 µm, and is preferably 0.05 µm or more, more preferably 0.1 µm or more, and still more preferably 0.2 µm or more from the viewpoint of maintaining the film strength, and is preferably 8 µm or less, more preferably 5 µm or less, still more preferably 2 µm or less, and still more preferably 1 µm or less from the viewpoint of avoiding nonuniformity caused by a thick film.

The method for forming the release agent layer from the release agent composition will be described in detail in the description of <<Method for Producing One Example of Laminate in First Embodiment>> described below.

### <<Adhesion Layer>>

The adhesion layer is provided between the support substrate and the semiconductor substrate.

The adhesion layer is in contact with, for example, the semiconductor substrate. The adhesion layer may be in contact with the support substrate, for example.

The adhesion layer is not particularly limited, but is preferably a layer formed of an adhesive composition.

### <<Adhesive Composition>>

Examples of the adhesive composition include, but are not limited to, a polysiloxane-based adhesive, an acrylic resin-based adhesive, an epoxy resin-based adhesive, a polyamide-based adhesive, a polystyrene-based adhesive, a polyimide adhesive, and a phenol resin-based adhesive.

Among them, a polysiloxane-based adhesive is preferable as the adhesive composition because the adhesive composition exhibits suitable adhesive ability during processing of a semiconductor substrate or the like, can be suitably released after processing, is further excellent in heat resistance, and can be suitably removed by the cleaning agent composition.

In a preferred aspect, the adhesive composition contains a polyorganosiloxane.

In another preferred aspect, the adhesive composition contains a component that cures by a hydrosilylation reaction.

For example, the adhesive composition used in the present invention contains a curable component (A) to be an adhesive component. The adhesive composition used in the present invention may contain a component (A) that cures to be an adhesive component and a component (B) that does not cause a curing reaction. Here, examples of the component (B) that does not cause a curing reaction include polyorganosiloxanes. In the present invention, "not causing a curing reaction" does not mean not causing any curing reaction, but means not causing a curing reaction occurring in the component (A) to be cured.

In a preferred aspect, the component (A) may be a component that is cured by a hydrosilylation reaction or a polyorganosiloxane component (A') that is cured by a hydrosilylation reaction.

In another preferred aspect, the component (A) contains, for example, as an example of the component (A'), a polyorganosiloxane (a1) having an alkenyl group having 2 to 40 carbon atoms bonded to a silicon atom, a polyorganosiloxane (a2) having a Si-H group, and a platinum group metal-based catalyst (A2). Here, the alkenyl group having 2 to 40 carbon atoms may be optionally substituted. Examples of these substituents include a halogen atom, a nitro group, a cyano group, an amino group, a hydroxyl group, a carboxyl group, an aryl group, and a heteroaryl group.

In another preferred aspect, the polyorganosiloxane component (A') cured by the hydrosilylation reaction includes a polysiloxane (A1) containing one or more units selected from the group consisting of siloxane units represented by SiO₂ (Q units), siloxane units represented by R¹R²R³SiO_{1/2} (M units), siloxane units represented by R⁴R⁵SiO_{2/2} (D units), and siloxane units represented by R⁶SiO_{3/2} (T units), and a platinum group metal-based catalyst (A2). The polysiloxane (A1) contains polyorganosiloxane (al') that contains one or more units selected from the group consisting of siloxane units represented by SiO₂ (Q' units), siloxane units represented by R¹'R²'R³'SiO_{1/2} (M' units), siloxane units represented by R⁴'R⁵'SiO_{2/2} (D' units), and siloxane units represented by R⁶'SiO_{3/2} (T' units), and contains at least one unit selected from the group consisting of M' units, D' units, and T' units; and polyorganosiloxane (a2') that contains one or more units selected from the group consisting of siloxane units represented by SiO₂ (Q" units), siloxane units represented by R¹"R²"R³"SiO_{1/2} (M" units), siloxane units represented by R⁴"R⁵"SiO_{2/2} (D" units), and siloxane units represented by R⁶"SiO_{3/2} (T" units), and contains at least one unit selected from the group consisting of M" units, D" units, and T" units.

Note that (al') is an example of (a1), and (a2') is an example of (a2).

R¹ to R⁶ are groups or atoms bonded to a silicon atom, and each independently represent an optionally substituted alkyl group, an optionally substituted alkenyl group, or a hydrogen atom. Examples of these substituents include a halogen atom, a nitro group, a cyano group, an amino group, a hydroxyl group, a carboxyl group, an aryl group, and a heteroaryl group.

R¹' to R⁶' are groups bonded to a silicon atom and each independently represent an optionally substituted alkyl group or an optionally substituted alkenyl group, but at least one of R¹' to R⁶' is an optionally substituted alkenyl group. Examples of these substituents include a halogen atom, a nitro group, a cyano group, an amino group, a hydroxyl group, a carboxyl group, an aryl group, and a heteroaryl group.

R¹" to R⁶" are groups or atoms bonded to a silicon atom and each independently represent an optionally substituted alkyl group or a hydrogen atom, but at least one of R¹" to R⁶" is a hydrogen atom. Examples of these substituents include a halogen atom, a nitro group, a cyano group, an amino group, a hydroxyl group, a carboxyl group, an aryl group, and a heteroaryl group.

The alkyl group may be linear, branched, or cyclic, but is preferably a linear or branched alkyl group, and the number of carbon atoms thereof is not particularly limited, but is usually 1 to 40, preferably 30 or less, more preferably 20 or less, and still more preferably 10 or less.

Specific examples of the optionally substituted linear or branched alkyl group include, but not limited to, a methyl group, an ethyl group, a n-propyl group, an i-propyl group, a n-butyl group, an i-butyl group, a s-butyl group, a tertiary butyl group, a n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, a n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group, and the number of carbon atoms thereof is usually 1 to 14, preferably 1 to 10, and more preferably 1 to 6. Among them, a methyl group is particularly preferable.

Specific examples of the optionally substituted cyclic alkyl group include, but are not limited to, a cycloalkyl group such as a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2 methyl-cyclopropyl group, a 2-ethyl-1 methyl-cyclopropyl group, a 2-ethyl-2 methyl-cyclopropyl group, and a 2-ethyl-3-methyl-cyclopropyl group, and bicycloalkyl groups such as a bicyclobutyl group, a bicyclopentyl group, a bicyclohexyl group, a bicycloheptyl group, a bicyclooctyl group, a bicyclononyl group, and a bicyclodecyl group, and the number of carbon atoms thereof is usually 3 to 14, preferably 4 to 10, and more preferably 5 to **6.**

The alkenyl group may be linear or branched, and the number of carbon atoms thereof is not particularly limited, but is usually 2 to 40, preferably 30 or less, more preferably 20 or less, and still more preferably 10 or less.

Specific examples of the optionally substituted linear or branched alkenyl group include, but are not limited to, a vinyl group, an allyl group, a butenyl group, and a pentenyl group, and the number of carbon atoms thereof is usually 2 to 14, preferably 2 to 10, and more preferably 1 to 6. Among them, an ethenyl group and a 2-propenyl group are particularly preferable.

Specific examples of the optionally substituted cyclic alkenyl group, but are not limited to, cyclopentenyl and cyclohexenyl, and the number of carbon atoms thereof is usually 4 to 14, preferably 5 to 10, and more preferably 5 to 6.

As described above, the polysiloxane (A1) contains a polyorganosiloxane (al') and a polyorganosiloxane (a2'), and an alkenyl group contained in the polyorganosiloxane (al') and a hydrogen atom (Si-H group) contained in the polyorganosiloxane (a2') form a crosslinked structure by a hydrosilylation reaction by the platinum group metal-based catalyst (A2) and are cured. As a result, a cured film is formed.

The polyorganosiloxane (al') contains one or more units selected from the group consisting of Q' units, M' units, D' units, and T' units, and contains at least one selected from the group consisting of M' units, D' units, and T' units. As the polyorganosiloxane (a1'), two or more kinds of polyorganosiloxanes satisfying such conditions may be used in combination.

Preferred combinations of two or more selected from the group consisting of Q' units, M' units, D' units, and T' units include, but are not limited to, (Q' units and M' units), (D' units and M' units), (T' units and M' units), and (Q' units, T' units, and M' units).

When two or more kinds of polyorganosiloxanes contained in polyorganosiloxane (a1'), a combination of (Q' unit and M' unit) and (D' unit and M' unit), a combination of (T' unit and M' unit) and (D' unit and M' unit), and a combination of (Q' unit, T' unit, and M' unit) and (T' unit and M' unit) are preferable, but the combinations are not limited thereto.

The polyorganosiloxane (a2') contains one or more units selected from the group consisting of Q" units, M" units, D" units, and T" units, and contains at least one selected from the group consisting of M" units, D" units, and T" units. As the polyorganosiloxane (a2'), two or more kinds of polyorganosiloxanes satisfying such conditions may be used in combination.

Preferred combinations of two or more selected from the group consisting of Q" units, M" unit, D" units, and T" units include, but are not limited to, (M" unit and D" unit), (Q" unit and M" unit), and (Q" unit, T" unit, and M" unit).

The polyorganosiloxane (al') is composed of siloxane units in which alkyl groups and/or alkenyl groups are bonded to silicon atoms thereof, and the proportion of alkenyl groups in the total substituents represented by R¹' to R⁶' is preferably 0.1 to 50.0% by mol and more preferably 0.5 to 30.0% by mol, and the remaining R¹' to R⁶' can be alkyl groups.

The polyorganosiloxane (a2') is composed of siloxane units in which alkyl groups and/or hydrogen atoms are bonded to silicon atoms thereof, and the proportion of hydrogen atoms in all substituents represented by R¹" to R⁶" and substituted atoms is preferably 0.1 to 50.0% by mol and more preferably 10.0 to 40.0% by mol, and the remaining R¹" to R⁶" can be alkyl groups.

When the component (A) contains (a1) and (a2), in a preferred aspect of the present invention, the molar ratio of the alkenyl group contained in the polyorganosiloxane (a1) and the hydrogen atom constituting the Si-H bond contained in the polyorganosiloxane (a2) is in the range of 1.0:0.5 to 1.0:0.66.

The weight average molecular weight of the polysiloxane such as the polyorganosiloxane (a1) or the polyorganosiloxane (a2) is not particularly limited, but is usually 500 to 1,000,000, and is preferably 5,000 to 50,000 from the viewpoint of reproducibly realizing the effects of the present invention.

In the present invention, the weight average molecular weight, the number average molecular weight, and the dispersibility of the polyorganosiloxane (excluding the organosiloxane polymer) can be measured, for example, using a GPC apparatus (EcoSEC, HLC-8320GPC manufactured by Tosoh Corporation) and a GPC column (TSKgel SuperMultiporeHZ-N and TSKgel SuperMultiporeHZ-H manufactured by Tosoh Corporation), at a column temperature of 40°C, using tetrahydrofuran as an eluent (eluent solvent), at a flow rate (flow velocity) of 0.35 mL/min, and using polystyrene (Shodex manufactured by Showa Denko K.K.) as a standard sample.

The viscosity of each of the polyorganosiloxane (a1) and the polyorganosiloxane (a2) is not particularly limited, but is usually 10 to 1,000,000 (mPa·s), and is preferably 50 to 10,000 (mPa·s) from the viewpoint of reproducibly realizing the effects of the present invention. The viscosity of the polyorganosiloxane (a1) and the polyorganosiloxane (a2) are values measured with an E-type rotational viscometer at 25°C.

The polyorganosiloxane (a1) and the polyorganosiloxane (a2) react with each other by a hydrosilylation reaction to form a film. Therefore, the mechanism of curing is different from that via, for example, a silanol group, and therefore, any siloxane does not need to contain silanol groups or functional groups, such as alkoxy groups, that form silanol groups through hydrolysis.

In a preferred aspect of the present invention, the adhesive composition contains a platinum group metal-based catalyst (A2) together with the polyorganosiloxane component (A').

Such a platinum-based metal catalyst is a catalyst for promoting the hydrosilylation reaction between the alkenyl group of the polyorganosiloxane (a1) and the Si-H group of the polyorganosiloxane (a2).

Specific examples of the platinum-based metal catalyst include, but are not limited to, platinum-based catalysts such as platinum black, second platinum chloride, chloroplatinic acid, a reaction product of chloroplatinic acid and monohydric alcohol, a complex of chloroplatinic acid and olefins, and platinum bisacetoacetate.

Examples of the complex of platinum and olefins include, but are not limited to, a complex of divinyltetramethyldisiloxane and platinum.

The amount of the platinum group metal-based catalyst (A2) is not particularly limited, but is usually in the range of 1.0 to 50.0 ppm with respect to the total amount of the polyorganosiloxane (a1) and the polyorganosiloxane (a2).

The polyorganosiloxane component (A') may contain a polymerization inhibitor (A3) for the purpose of suppressing the progress of the hydrosilylation reaction.

The polymerization inhibitor is not particularly limited as long as the polymerization inhibitor can suppress the progress of the hydrosilylation reaction, and specific examples thereof include alkynyl alcohols such as 1-ethynyl-1-cyclohexanol and 1,1-diphenyl-2-propion-1-ol.

The amount of the polymerization inhibitor is not particularly limited, but is usually 1000.0 ppm or more with respect to the total amount of the polyorganosiloxane (a1) and the polyorganosiloxane (a2) from the viewpoint of obtaining the effect, and is 10,000.0 ppm or less from the viewpoint of preventing excessive suppression of the hydrosilylation reaction.

An example of the adhesive composition used in the present invention may include the component (A) that cures and the component (B) that does not cause a curing reaction as a release agent component. By including such a component (B) in the adhesive composition, the obtained adhesion layer can be suitably released with good reproducibility.

Typical examples of the component (B) include, but are not limited to, non-curable polyorganosiloxanes, and specific examples thereof include epoxy group-containing polyorganosiloxanes, methyl group-containing polyorganosiloxanes, and phenyl group-containing polyorganosiloxanes.

Examples of the component (B) include polydimethylsiloxane. The polydimethylsiloxane may be modified. Examples of the polydimethylsiloxane which may be modified include, but are not limited to, epoxy group-containing polydimethylsiloxane, unmodified polydimethylsiloxane, and phenyl group-containing polydimethylsiloxane.

Preferred examples of the polyorganosiloxane as the component (B) include, but are not limited to, epoxy group-containing polyorganosiloxanes, methyl group-containing polyorganosiloxanes, and phenyl group-containing polyorganosiloxanes.

The weight average molecular weight of the polyorganosiloxane as the component (B) is not particularly limited, but is usually 100,000 to 2,000,000, and is preferably 200,000 to 1,200,000, and more preferably 300,000 to 900,000 from the viewpoint of reproducibly realizing the effects of the present invention. In addition, the dispersibility is not particularly limited, but is usually 1.0 to 10.0, and is preferably 1.5 to 5.0, and more preferably 2.0 to 3.0 from the viewpoint of realizing suitable release with good reproducibility. The weight average molecular weight and the dispersibility can be measured by the above-described method related to the polyorganosiloxane.

The viscosity of the polyorganosiloxane as the component (B) is not particularly limited, but is usually 1,000 to 2,000,000 mm²/s. The value of the viscosity of the polyorganosiloxane as the component (B) is expressed by kinematic viscosity, and centistokes (cSt) = mm²/s. The value can also be determined by dividing the viscosity (mPa·s) by the density (g/cm³). That is, the value can be determined from the viscosity and density measured with an E-type rotational viscometer measured at 25°C, and can be calculated from the equation: kinematic viscosity (mm²/s) = viscosity (mPa·s)/density (g/cm³).

Examples of the epoxy group-containing polyorganosiloxane include those containing siloxane units (D¹⁰ units) represented by R¹¹R¹²SiO_{2/2}.

R¹¹ is a group bonded to a silicon atom and represents an alkyl group, R¹² is a group bonded to a silicon atom and represents an epoxy group or an organic group containing an epoxy group, and specific examples of the alkyl group can include the above-described examples.

The epoxy group in the organic group containing an epoxy group may be an independent epoxy group without being fused with other rings, or may be an epoxy group forming a fused ring with other rings, such as a 1,2-epoxycyclohexyl group.

Specific examples of the organic group containing an epoxy group include, but are not limited to, 3-glycidoxypropyl and 2-(3,4-epoxycyclohexyl)ethyl.

In the present invention, preferred examples of the epoxy group-containing polyorganosiloxane include, but are not limited to, epoxy group-containing polydimethylsiloxane.

The epoxy group-containing polyorganosiloxane contains the above-described siloxane units (D¹⁰ units), but may contain Q units, M units, and/or T units in addition to the D¹⁰ units.

In a preferred aspect of the present invention, specific examples of the epoxy group-containing polyorganosiloxane include polyorganosiloxanes composed only of D¹⁰ units, polyorganosiloxanes containing D¹⁰ units and Q units, polyorganosiloxanes containing D¹⁰ units and M units, polyorganosiloxanes containing D¹⁰ units and T units, polyorganosiloxanes containing D¹⁰ units, Q units, and M units, polyorganosiloxanes containing D¹⁰ units, M units, and T units, and polyorganosiloxanes containing D¹⁰ units, Q units, M units, and T units.

The epoxy group-containing polyorganosiloxane is preferably an epoxy group-containing polydimethylsiloxane having an epoxy value of 0.1 to 5. The weight average molecular weight thereof is not particularly limited, but is usually 1,500 to 500,000, and is preferably 100,000 or less from the viewpoint of suppressing precipitation in the composition.

Specific examples of the epoxy group-containing polyorganosiloxane include, but are not limited to, those represented by the Formulae (E1) to (E3). 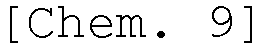 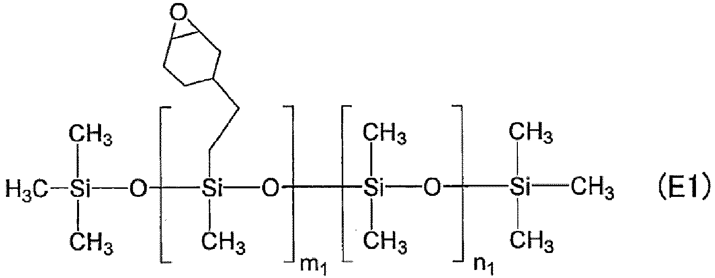 (m₁ and n₁ represent the number of each repeating unit, and are positive integers.) 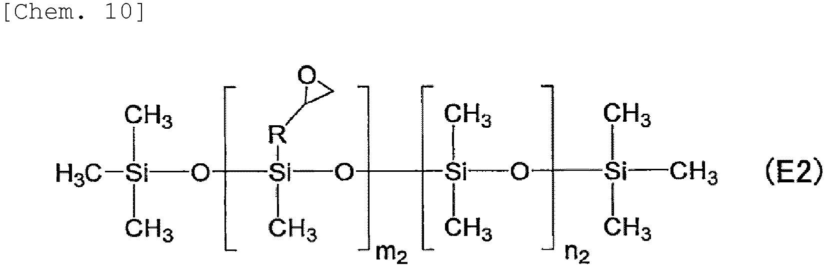 (m₂ and n₂ represent the number of each repeating unit and are positive integers, and R is an alkylene group having 1 to 10 carbon atoms.) 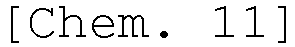 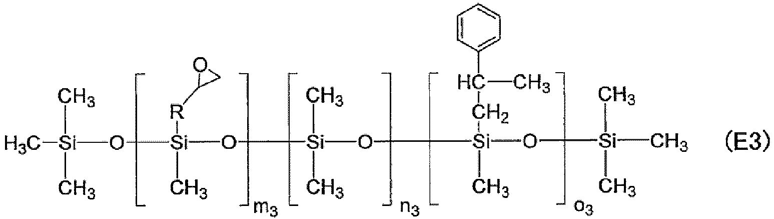 (m₃, n₃, and o₃ represent the number of each repeating unit, and are positive integers, and R is an alkylene group having 1 to 10 carbon atoms.)

Examples of the methyl group-containing polyorganosiloxane include those containing siloxane units (D²⁰⁰ units) represented by R²¹⁰R²²⁰SiO_{2/2}, and those containing siloxane units (D²⁰ units) preferably represented by R²¹R²¹SiO_{2/2}.

R²¹⁰ and R²²⁰ are groups bonded to silicon atoms, and each independently represent an alkyl group, but at least one thereof is a methyl group, and specific examples of the alkyl group can include the above-described examples.

R²¹ is a group bonded to silicon atoms and represents an alkyl group, and specific examples of the alkyl group can include the above examples. Among them, R²¹ is preferably a methyl group.

In the present invention, preferred examples of the methyl group-containing polyorganosiloxane include, but are not limited to, polydimethylsiloxane.

The methyl group-containing polyorganosiloxane contains the above-described siloxane units (D²⁰⁰ units or D²⁰ units), but may contain Q units, M units, and/or T units in addition to D²⁰⁰ units and D²⁰ units.

In an aspect of the present invention, specific examples of the methyl group-containing polyorganosiloxane include polyorganosiloxanes composed only of D²⁰⁰ units, polyorganosiloxanes containing D²⁰⁰ units and Q units, polyorganosiloxanes containing D²⁰⁰ units and M units, polyorganosiloxanes containing D²⁰⁰ units and T units, polyorganosiloxanes containing D²⁰⁰ units, Q units, and M units, polyorganosiloxanes containing D²⁰⁰ units, M units, and T units, and polyorganosiloxanes containing D²⁰⁰ units, Q units, M units, and T units.

In a preferred aspect of the present invention, specific examples of the methyl group-containing polyorganosiloxane include polyorganosiloxanes composed only of D²⁰ units, polyorganosiloxanes containing D²⁰ units and Q units, polyorganosiloxanes containing D²⁰ units and M units, polyorganosiloxanes containing D²⁰ units and T units, polyorganosiloxanes containing D²⁰ units, Q units, and M units, polyorganosiloxanes containing D²⁰ units, M units, and T units, and polyorganosiloxanes containing D²⁰ units, Q units, M units, and T units.

Specific examples of the methyl group-containing polyorganosiloxane include, but are not limited to, those represented by the Formula (M1). 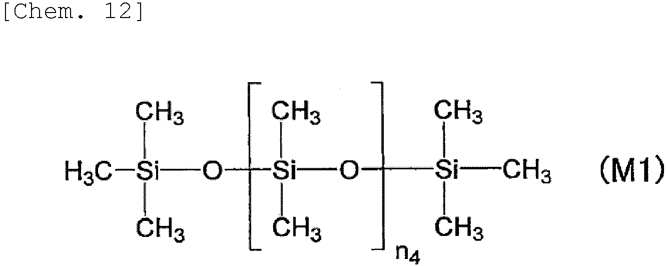 (n₄ represents the number of repeating units, and is a positive integer.)

Examples of the phenyl group-containing polyorganosiloxane include those containing siloxane units (D³⁰ units) represented by R³¹R³²SiO_{2/2}.

R³¹ is a group bonded to silicon atoms and represents a phenyl group or an alkyl group, R³² is a group bonded to silicon atoms and represents a phenyl group, and specific examples of the alkyl group include the above-described examples, but a methyl group is preferable.

The phenyl group-containing polyorganosiloxane contains the above-described siloxane units (D³⁰ units), but may contain Q units, M units, and/or T units in addition to the D³⁰ units.

In a preferred aspect of the present invention, specific examples of the phenyl group-containing polyorganosiloxane include polyorganosiloxanes composed only of D³⁰ units, polyorganosiloxanes containing D³⁰ units and Q units, polyorganosiloxanes containing D³⁰ units and M units, polyorganosiloxanes containing D³⁰ units and T units, polyorganosiloxanes containing D³⁰ units, Q units, and M units, polyorganosiloxanes containing D³⁰ units, M units, and T units, and polyorganosiloxanes containing D³⁰ units, Q units, M units, and T units.

Specific examples of the phenyl group-containing polyorganosiloxane include, but are not limited to, those represented by the Formula (P1) or (P2). 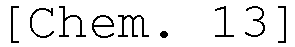 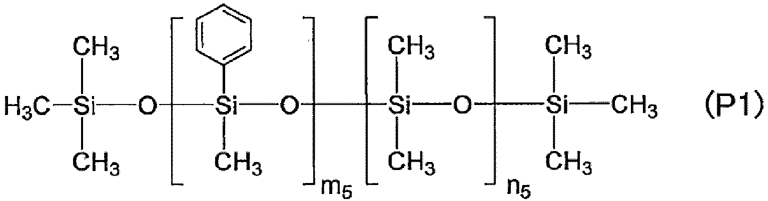 (m₅ and n₅ represent the number of each repeating unit, and are positive integers.) 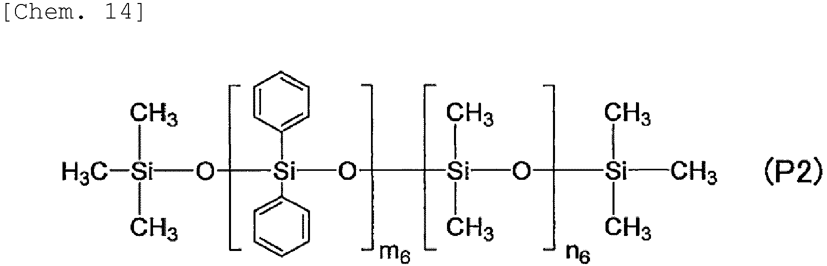 (m₆ and n₆ represent the number of each repeating unit, and are positive integers.)

The polyorganosiloxane as the release agent component (B) may be a commercially available product or a synthetic product.

Examples of commercially available products of the polyorganosiloxane include, but are not limited to, WACKER SILICONE FLUID AK series (AK 50, AK 350, AK 1000, AK 10000, AK 1000000) and GENIOPLAST GUM, which are products manufactured by Wacker Chemie AG, and dimethyl silicone oil (KF-96L, KF-96A, KF-96, KF-96H, KF-69, KF-965, KF-968) and cyclic dimethyl silicone oil (KF-995) manufactured by Shin-Etsu Chemical Co., Ltd.; epoxy group-containing polyorganosiloxane manufactured by Gelest, Inc. (trade name: CMS-227, ECMS-327), epoxy group-containing polyorganosiloxane (KF-101, KF-1001, KF-1005, X-22-343) manufactured by Shin-Etsu Chemical Co., Ltd., and epoxy group-containing polyorganosiloxane (BY16-839) manufactured by Dow Corning Corporation; and phenyl group-containing polyorganosiloxane (PMM-1043, PMM-1025, PDM-0421, PDM-0821) manufactured by Gelest, Inc, phenyl group-containing polyorganosiloxane (KF50-3000CS) manufactured by Shin-Etsu Chemical Co., Ltd., and phenyl group-containing polyorganosiloxane (TSF 431, TSF 433) manufactured by Momentive Performance Materials, Inc.

In one aspect, the adhesive composition used in the present invention contains a curable component (A) and a component (B) that does not cause a curing reaction, and in another aspect, a polyorganosiloxane is contained as the component (B).

An example of the adhesive composition used in the present invention can contain the component (A) and the component (B) in any ratio, but in consideration of the balance between adhesiveness and releasability, the ratio of the component (A) and the component (B) is preferably 99.995:0.005 to 30:70, and more preferably 99.9:0.1 to 75:25 in mass ratio [(A):(B)].

That is, when the polyorganosiloxane component (A') cured by a hydrosilylation reaction is contained, the ratio of the component (A') to the component (B) is preferably 99.995:0.005 to 30:70, and more preferably 99.9:0.1 to 75:25 in mass ratio [(A'):(B)].

The viscosity of the adhesive composition used in the present invention is not particularly limited, but is usually 500 to 20,000 mPa·s and preferably 1,000 to 10,000 mPa·s at 25°C.

An example of the adhesive composition used in the present invention can be produced by mixing the component (A) with the component (B) and a solvent when used.

The mixing order is not particularly limited, but examples of the method for easily and reproducibly producing the adhesive composition include, but are not limited to, a method in which the component (A) and the component (B) are dissolved in a solvent, and a method in which a part of the component (A) and the component (B) is dissolved in a solvent, the rest is dissolved in a solvent, and the obtained solution is mixed. When the adhesive composition is prepared, the adhesive composition may be appropriately heated as long as the components are not decomposed or altered.

In the present invention, for the purpose of removing foreign substances, a solvent, a solution, or the like to be used may be filtered using a filter or the like during the production of the adhesive composition or after mixing all the components.

The thickness of the adhesion layer included in the laminate of the present invention is not particularly limited, but is usually 5 to 500 µm, and is preferably 10 µm or more, more preferably 20 µm or more, and still more preferably 30 µm or more from the viewpoint of maintaining the film strength, and is preferably 200 µm or less, more preferably 150 µm or less, still more preferably 120 µm or less, and still more preferably 70 µm or less from the viewpoint of avoiding nonuniformity caused by a thick film.

The method for forming the adhesion layer from the adhesive composition will be described in detail in the description of <<Method for Producing One Example of Laminate in First Embodiment>> described below.

Hereinafter, an example of the configuration of the laminate of the first embodiment will be described with reference to the drawings.

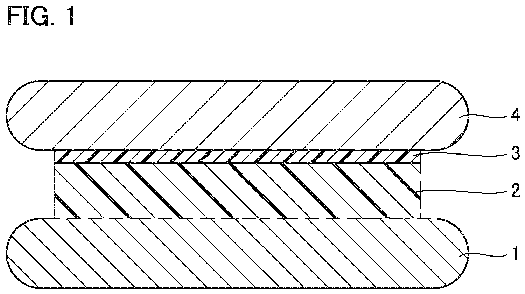

Fig. 1 shows a schematic cross-sectional view of an example of the laminate of the first embodiment.

The laminate of Fig. 1 includes a semiconductor substrate 1, an adhesion layer 2, a release agent layer 3, and a support substrate 4 in this order.

The adhesion layer 2 and the release agent layer 3 are provided between the semiconductor substrate 1 and the support substrate 4. The adhesion layer 2 is in contact with the semiconductor substrate 1. The release agent layer 3 is in contact with the adhesion layer 2 and the support substrate 4.

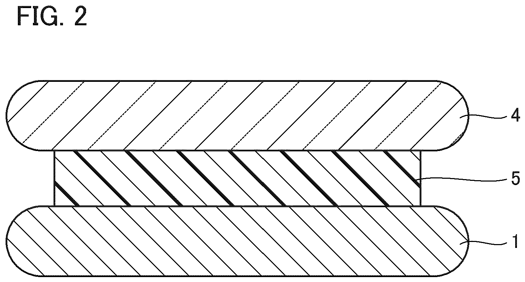

Further, another example of the configuration of the laminate of the first embodiment is shown in Fig. 2.

When the release agent layer according to the present invention is a release agent layer having both a release function and an adhesive function and having adhesive performance, the laminate may be formed not in a two-layer structure of the release agent layer and the adhesion layer but in a one-layer structure of the release agent layer having adhesive performance.

Fig. 2 is a schematic cross-sectional view of another example of the laminate.

The laminate of Fig. 2 includes the semiconductor substrate 1, a release agent layer 5 having adhesive performance, and the support substrate 4 in this order.

The release agent layer 5 is provided between the semiconductor substrate 1 and the support substrate 4. The release agent layer 5 can be prepared by mixing components of a release agent composition that forms a release agent with components of an adhesive composition that forms an adhesion layer.

### <<Method for Producing One Example of Laminate in First Embodiment>>

A method for producing a laminate will be described below with the laminate shown in Fig. 1 as an example of the laminate in the first embodiment.

The laminate of the present invention can be produced, for example, by a method including a first step of coating a surface of a semiconductor substrate with an adhesive composition and, if necessary, heating the adhesive composition to form an adhesive coating layer, a second step of coating a surface of a support substrate with a release agent composition and, if necessary, heating the release agent composition to form a release agent coating layer, and a third step of bringing the adhesive coating layer of the semiconductor substrate and the release agent coating layer of the support substrate into close contact with each other by applying a load in the thickness direction of the semiconductor substrate and the support substrate while performing at least one of heat treatment and decompression treatment, and then performing post-heat treatment to form a laminate.

Note that, in Fig. 1, in the laminate, the semiconductor substrate 1, the adhesion layer 2, the release agent layer 3, and the support substrate 4 are stacked in this order, and thus the above-described production method has been exemplified. However, for example, when producing the laminate in which the semiconductor substrate 1, the release agent layer 3, the adhesion layer 2, and the support substrate 4 are stacked in this order, the laminate can be produced by a method including a first step of coating a surface of a semiconductor substrate with a release agent composition and, if necessary, heating the release agent composition to form a release agent coating layer, a second step of coating a surface of a support substrate with an adhesive composition and, if necessary, heating the adhesive composition to form an adhesive coating layer, and a third step of bringing the release agent coating layer of the semiconductor substrate and the adhesive coating layer of the support substrate into close contact with each other by applying a load in the thickness direction of the semiconductor substrate and the support substrate while performing at least one of heat treatment and decompression treatment, and then performing post-heat treatment to form a laminate.

As long as the effect of the present invention is not impaired, coating and heating of each composition may be sequentially performed on any one of the substrates.

The coating method is not particularly limited, but is usually a spin coating method. Incidentally, a method of separately forming a coating film by a spin coating method or the like and attaching a sheet-like coating film as an adhesive coating layer can be adopted.

The heating temperature of the applied adhesive composition varies depending on the type and amount of the adhesive component contained in the adhesive composition, whether or not a solvent is contained, the boiling point of the solvent used, the desired thickness of the adhesion layer, and the like, and thus cannot be generally specified, but the heating temperature is usually 80 to 150°C, and the heating time is usually 30 seconds to 5 minutes.

When the adhesive composition contains a solvent, the applied adhesive composition is usually heated.

The heating temperature of the applied release agent composition varies depending on the type and amount of the release agent component contained in the release agent composition, the desired thickness of the release agent layer, and the like, and thus cannot be generally defined, but from the viewpoint of reproducibly realizing a suitable release agent layer, the heating temperature is 80°C or higher and 300°C or lower, and the heating time is appropriately determined usually in the range of 10 seconds to 10 minutes depending on the heating temperature. The heating temperature is preferably 100°C or higher and 280°C or lower, and more preferably 150°C or higher and 250°C or lower. The heating time is preferably 30 seconds or more and 8 minutes or less, and more preferably 1 minute or more and 5 minutes or less.

Heating can be performed using a hot plate, an oven, or the like.

The film thickness of an adhesive coating layer obtained by applying an adhesive composition and heating the adhesive composition as necessary is usually about 5 to 500 µm, and finally, is appropriately determined to fall within the above-described range of the thickness of the adhesion layer.

The film thickness of a release agent coating layer obtained by applying a release agent composition and heating the release agent composition as necessary is usually about 5 nm to 500 µm, and finally, is appropriately determined to fall within the above-described range of the thickness of the release agent layer.

In the present invention, the laminate of the present invention can be obtained by combining such coating layers to be in contact with each other, bringing the two layers into close contact with each other by applying a load in the thickness direction of the semiconductor substrate and the support substrate while performing heat treatment or decompression treatment or both thereof, and then performing post-heat treatment. Which treatment condition of heat treatment, decompression treatment, and combination use of both is adopted is appropriately determined in consideration of various circumstances such as the type of the adhesive composition, the specific composition of the release agent composition, the compatibility of the films obtained from both compositions, the film thickness, and the required adhesive strength.

The heat treatment is usually appropriately determined from the range of 20 to 150°C from the viewpoint of removing the solvent from the composition, the viewpoint of softening the adhesive coating layer to realize suitable bonding with the release agent coating layer, and the like. In particular, from the viewpoint of suppressing or avoiding excessive curing and unnecessary alteration of the adhesive component (A), the heating temperature is preferably 130°C or lower, more preferably 90°C or lower, and the heating time is appropriately determined according to the heating temperature and the type of the adhesive. However, from the viewpoint of reliably exhibiting suitable adhesion, the heating time is usually 30 seconds or longer, and preferably 1 minute or longer. From the viewpoint of suppressing alteration of the adhesion layer and other members, the heating time is usually 10 minutes or shorter, and preferably 5 minutes or shorter.

In the decompression treatment, the adhesive coating layer and the release agent coating layer which are in contact with each other may be exposed to an atmospheric pressure of 10 to 10,000 Pa. The time for the decompression treatment is usually 1 to 30 minutes.

From the viewpoint of obtaining a laminate in which the substrate can be satisfactorily separated with good reproducibility, the two layers which are in contact with each other are bonded to each other preferably by decompression treatment, and more preferably by combined use of heat treatment and decompression treatment.

The load in the thickness direction of the semiconductor substrate and the support substrate is not particularly limited as long as the load does not adversely affect the semiconductor substrate, the support substrate, and the two layers therebetween and can bring the semiconductor substrate, the support substrate, and the two layers therebetween into firmly close contact with each other, but is usually within the range of 10 to 1,000 N.

The post-heating temperature is preferably 120°C or higher from the viewpoint of achieving a sufficient curing speed and the like, and is preferably 260°C or lower from the viewpoint of preventing alteration of the substrate and each layer and the like.

The post-heating time is usually 1 minute or longer, and preferably 5 minutes or longer from the viewpoint of realizing suitable bonding of the substrate and the layer constituting the laminate, and is usually 180 minutes or shorter, and preferably 120 minutes or shorter from the viewpoint of suppressing or avoiding an adverse effect on each layer due to excessive heating.

Heating can be performed using a hot plate, an oven, or the like. When post-heating is performed using a hot plate, heating may be performed with either the semiconductor substrate or the support substrate of the laminate facing downward, but it is preferable to perform post-heating with the semiconductor substrate facing downward from the viewpoint of realizing suitable release with good reproducibility.

One object of the post-heat treatment is to realize an adhesion layer and a release agent layer which are more suitable self-standing films, and particularly to suitably realize curing by a hydrosilylation reaction.

### <Second Embodiment>

The laminate having the electronic device layer is used for processing the electronic device layer. While the electronic device layer is subjected to processing, the electronic device layer is adhered to the support substrate via the adhesion layer. After processing the electronic device layer, the release agent layer is irradiated with light, and then the electronic device layer is separated from the support substrate.

### <<Electronic Device Layer>>

The electronic device layer refers to a layer having an electronic device, and in the present invention, refers to a layer in which a plurality of semiconductor chip substrates are embedded in a sealing resin, that is, a layer including a plurality of semiconductor chip substrates and a sealing resin disposed between the semiconductor chip substrates.

Here, the "electronic device" means a member constituting at least a part of the electronic component. The electronic device is not particularly limited, and various mechanical structures and circuits may be formed on the surface of the semiconductor substrate. The electronic device is preferably a composite of a member made of metal or a semiconductor and a resin that seals or insulates the member. The electronic device may be one in which a redistribution layer, which will be described later, and/or a semiconductor element or other elements are sealed or insulated with a sealing material or an insulating material, and has a single-layer or multi-layer structure.

### <<Support Substrate>>

As the support substrate, those similar to those described in the section of <<Support Substrate>> of <First Embodiment> above are exemplified.

### <<Release Agent Layer>>

The release agent layer is formed using the adhesive composition for light irradiation release of the present invention described above.

The detailed description of the release agent layer is as described in the section of <<Release Agent Layer>> of <First Embodiment> above.

### <<Adhesion Layer>>

The adhesion layer is formed using the adhesive composition described above.

The detailed description of the adhesion layer is as described in the section of <<Adhesive Layer>> of <First Embodiment> above.

Hereinafter, an example of a configuration of a laminate of a second embodiment will be described with reference to the drawings.

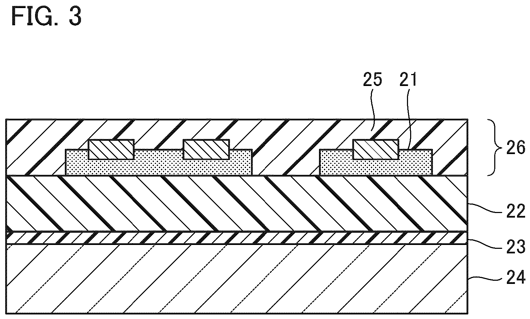

Fig. 3 shows a schematic cross-sectional view of an example of the laminate of the second embodiment.

The laminate of Fig. 3 includes a support substrate 24, a release agent layer 23, an adhesion layer 22, and an electronic device layer 26 in this order.

The electronic device layer 26 includes a plurality of semiconductor chip substrates 21 and a sealing resin 25 which is a sealing material disposed between the semiconductor chip substrates 21.

The adhesion layer 22 and the release agent layer 23 are provided between the electronic device layer 26 and the support substrate 24. The adhesion layer 22 is in contact with the electronic device layer 26. The release agent layer 23 is in contact with the adhesion layer 22 and the support substrate 24.

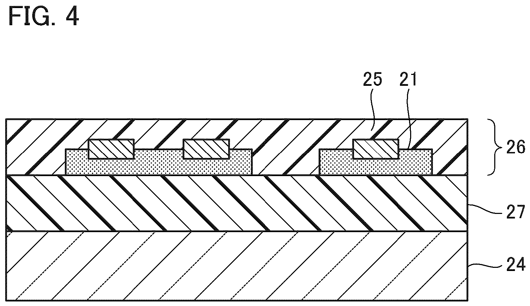

Further, another example of the configuration of the laminate of the second embodiment is shown in Fig. 4.

When the release agent layer according to the present invention is a release agent layer having both a release function and an adhesive function and having adhesive performance, the laminate may be formed not in a two-layer structure of the release agent layer and the adhesion layer but in a one-layer structure of the release agent layer having adhesive performance.

Fig. 4 is a schematic cross-sectional view of another example of the laminate.

The laminate of Fig. 4 includes the support substrate 24, a release agent layer 27 having adhesive performance, and the electronic device layer 26 in this order.

The release agent layer 27 having adhesive performance is provided between the support substrate 24 and the electronic device layer 26. The release agent layer 27 having adhesive performance can be prepared by mixing components of a release agent composition that forms a release agent with components of an adhesive composition that forms an adhesion layer.

### <<Method for Producing One Example of Laminate in Second Embodiment>>

A method for producing a laminate will be described below with the laminate shown in Fig. 3 as an example of the laminate in the second embodiment.

The laminate of the present invention can be produced, for example, by a method including a first step of coating the surface of the support substrate with the release agent composition to form a release agent coating layer (if necessary, further heating is performed to form a release agent layer), a second step of coating the surface of the release agent coating layer or the release agent layer with the adhesive composition to form an adhesive coating layer (if necessary, further heating is performed to form an adhesive layer), a third step of placing a semiconductor chip substrate on the adhesive coating layer or the adhesive layer and bonding the semiconductor chip substrate to the adhesive coating layer or the adhesive layer while performing at least one of heat treatment and decompression treatment, a fourth step of curing the adhesive coating layer by a post-heat treatment to form an adhesion layer, and a fifth step of sealing the semiconductor chip substrate fixed onto the adhesive layer using a sealing resin.

Describing the third step in more detail, for example, there is the following step (i) of the embodiment.
(i) The semiconductor chip substrate is placed on the adhesive coating layer or the adhesive layer, the semiconductor chip substrate and the adhesive coating layer or the adhesive layer are brought into close contact with each other by applying a load in the thickness direction of the semiconductor chip substrate and the support substrate while performing at least one of heat treatment and decompression treatment, and the semiconductor chip substrate is bonded to the adhesive coating layer or the adhesion layer.

Furthermore, the step of forming the adhesion layer by post-heating and curing the adhesive coating layer defined in the fourth step may be performed after the semiconductor chip substrate in the third step is bonded to the adhesive coating layer, or may be performed together with the third step. For example, by placing the semiconductor chip substrate on the adhesive coating layer and heating and curing the adhesive coating layer while applying a load in the thickness direction of the semiconductor chip substrate and the support substrate, close contact between the semiconductor chip substrate and the adhesive coating layer and curing from the adhesive coating layer to the adhesion layer may be performed together, and the adhesion layer and the semiconductor chip substrate may be bonded to each other.

In addition, the step of forming the adhesion layer by post-heating and curing the adhesive coating layer defined in the fourth step may be performed before the third step, or the adhesion layer and the semiconductor chip substrate may be bonded to each other while the semiconductor chip substrate is placed on the adhesive layer and a load in the thickness direction of the semiconductor chip substrate and the support substrate is applied.

The coating method, the heating temperature of the applied release agent composition or adhesive composition, the heating means, and the like are as described in <<Method for Producing One Example of Laminate in First Embodiment>> of <First embodiment>.

Hereinafter, the procedure of the method for producing the laminate of the second embodiment will be described in more detail with reference to the drawings.

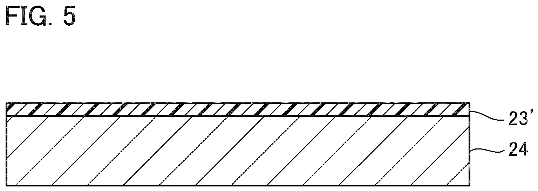

As shown in Fig. 5, a release agent coating layer 23' made of a release agent composition is formed on the support substrate 24. At that time, the release agent coating layer 23' may be heated to form the release agent layer 23.

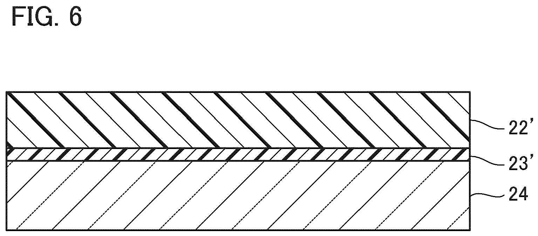

Next, as shown in Fig. 6, an adhesive coating layer 22' made of an adhesive composition is formed on the release agent coating layer 23' or the release agent layer 23. At that time, the adhesive coating layer 22' may be heated to form the adhesion layer 22.

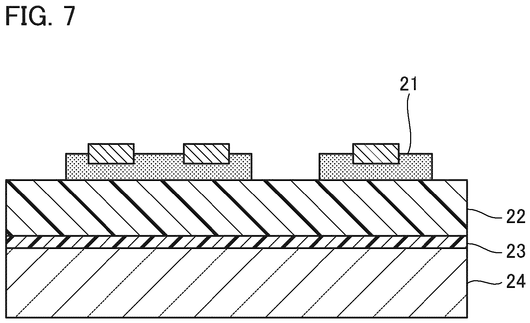

Next, as shown in Fig. 7, the semiconductor chip substrate 21 is placed on the adhesion layer 22 or the adhesive coating layer 22', the semiconductor chip substrate 21 and the adhesion layer 22 or the adhesive coating layer 22' are brought into close contact with each other by applying a load in the thickness direction of the semiconductor chip substrate 21 and the support substrate 24 while performing at least one of heat treatment and decompression treatment, and the semiconductor chip substrate 21 is bonded to the adhesion layer 22 or the adhesive coating layer 22'. When the semiconductor chip substrate 21 is bonded to the adhesive coating layer 22', the adhesive coating layer 22' is cured by post-heat treatment to form the adhesion layer 22, and the semiconductor chip substrate 21 is fixed to the adhesion layer 22.

Furthermore, when the adhesive coating layer 22' is subjected to the post-heat treatment, the release agent coating layer 23' may also be subjected to the post-heat treatment to form the release agent layer 23.

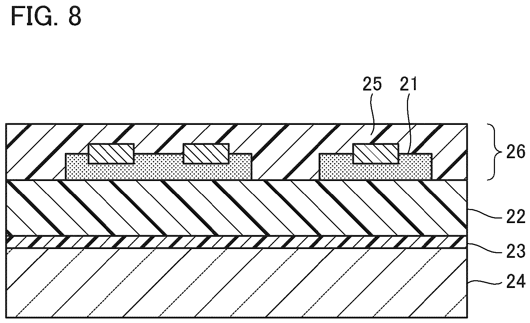

Next, as illustrated in Fig. 8, the semiconductor chip substrate 21 fixed to the adhesion layer 22 is sealed using the sealing resin 25. In Fig. 8, a plurality of semiconductor chip substrates 21 temporarily adhered onto the support substrate 24 via the adhesion layer 22 is sealed with the sealing resin 25. The electronic device layer 26 including the semiconductor chip substrate 21 and the sealing resin 25 disposed between the semiconductor chip substrates 21 is formed on the adhesion layer 22, and as described above, the electronic device layer 26 is a base material layer in which a plurality of semiconductor chip substrates are embedded in the sealing resin.

### <<<Sealing Step>>>

The semiconductor chip substrate 21 is sealed using a sealing material.

As a sealing material for sealing the semiconductor chip substrate 21, a member capable of insulating or sealing a member made of metal or a semiconductor is used.

In the present invention, for example, a resin composition is used as the sealing material. The type of the sealing resin is not particularly limited as long as the sealing resin can seal and/or insulate a metal or a semiconductor, but for example, an epoxy-based resin or a silicone-based resin is preferably used.

The sealing material may contain other components such as a filler in addition to the resin component. Examples of the filler include spherical silica particles.

In the sealing step, for example, a sealing resin heated to 130 to 170°C is supplied onto the adhesion layer 22 to cover the semiconductor chip substrate 21 while maintaining a high viscosity state, and is compression molded to form a layer including the sealing resin 25 on the adhesion layer 22. At this time, the temperature condition is, for example, 130 to 170°C. The pressure applied to the semiconductor chip substrate 21 is, for example, 50 to 500 N/cm².

### (Method of Producing Processed Semiconductor Substrate or Electronic Device Layer)

When the laminate according to the present invention is used, a method for producing a processed semiconductor substrate or a method for producing a processed electronic device layer can be provided.

In the "method for producing a processed semiconductor substrate", the laminate described in the section of <First Embodiment> of the (Laminate) above is used. In addition, in the "method for producing a processed electronic device layer", the laminate described in the section of <Second Embodiment> of the (Laminate) above is used.

The "method for producing a processed semiconductor substrate" will be described in the following <Third Embodiment>, and the "method for producing a processed electronic device layer" will be described in the following <Fourth Embodiment>.

### <Third Embodiment>

The method for producing a processed semiconductor substrate of the present invention includes the following step 5A and the following step 6A.

Here, the step 5A is a step of processing the semiconductor substrate in the laminate described in the section of <First Embodiment> above.

In addition, the step 6A is a step of separating the semiconductor substrate processed in the step 5A and the support substrate.

The processing performed on the semiconductor substrate in the step 5A is, for example, processing on the opposite side of the circuit surface of the wafer, and includes thinning of the wafer by polishing the back surface of the wafer. Thereafter, for example, a through silicon via (TSV) or the like is formed, and then the thinned wafer is released from the support substrate to form a laminate of wafers, and the wafer is three-dimensionally mounted. In addition, for example, a wafer back surface electrode and the like are also formed before and after that. Heat of about 250 to 350°C is applied to thinning of a wafer and a TSV process in a state of being adhered to a support substrate. The laminate of the present invention usually has heat resistance to the load including the adhesion layer.

Note that the processing is not limited to the above-described processing, and includes, for example, implementation of a process of mounting a semiconductor component in a case where the semiconductor component is temporarily adhered to a support substrate in order to support a base material for mounting the semiconductor component.

In the step 6A, examples of the method for separating (releasing) the semiconductor substrate from the support substrate include, but are not limited to, mechanical releasing with equipment having a sharp portion, releasing between the support and the semiconductor wafer, and the like after the release agent layer is irradiated with light.

By irradiating the release agent layer with light from the support substrate side, the release agent layer is altered (for example, separation or decomposition of the release agent layer) as described above, and thereafter, for example, one of the substrates is pulled up, and the semiconductor substrate and the support substrate can be easily separated from each other.

The release agent layer is not necessarily irradiated with light over the entire region of the release agent layer. Even when the region irradiated with light and the region not irradiated with light are mixed, the semiconductor substrate and the support substrate can be separated from each other by a slight external force such as pulling up of the support substrate as long as the release agent layer as a whole has sufficiently improved release ability. The ratio and positional relationship between the region irradiated with light and the region not irradiated with light vary depending on the type and specific composition of the adhesive to be used, the thickness of the adhesion layer, the thickness of the release agent layer, the intensity of light to be irradiated, and the like, but those skilled in the art can appropriately set conditions without requiring an excessive test. For such circumstances, according to the method for producing a processed semiconductor substrate of the present invention, for example, in a case where the support substrate of the laminate to be used has light transmissivity, it is possible to shorten the light irradiation time when release is performed by light irradiation from the support substrate side. As a result, not only improvement in throughput can be expected, but also physical stress and the like for release can be avoided, and the semiconductor substrate and the support substrate can be easily and efficiently separated from each other only by light irradiation.

Usually, the irradiation amount of light for release is 50 to 3,000 mJ/cm². The irradiation time is appropriately determined according to the wavelength and the irradiation amount.

As described above, the wavelength of light used for releasing is preferably, for example, a wavelength of 250 to 600 nm, and more preferably a wavelength of 250 to 370 nm. A more suitable wavelength is 308 nm, 343 nm, 355 nm, 365 nm, or 532 nm. The irradiation amount of light required for release is an irradiation amount that can cause suitable alteration, for example, decomposition of a specific light-absorbing compound.

The light used for release may be laser light or non-laser light emitted from a light source such as an ultraviolet lamp.

The substrate can be cleaned by spraying the cleaning agent composition onto the surface of at least one of the separated semiconductor substrate and support substrate, or immersing the separated semiconductor substrate or support substrate in the cleaning agent composition.

In addition, the surface of the processed semiconductor substrate or the like may be cleaned using a removal tape or the like.

The constituent elements and method elements related to the above-described steps of the method for producing a processed semiconductor substrate of the present invention may be variously changed without departing from the gist of the present invention.

The method for producing a processed semiconductor substrate of the present invention may include steps other than the above-described steps.

In the releasing method of the present invention, when the semiconductor substrate or the support substrate of the laminate of the present invention has light transmissivity, the semiconductor substrate and the support substrate of the laminate are separated from each other by irradiating the release agent layer with light from the semiconductor substrate side or the support substrate side.

In the laminate of the present invention, the semiconductor substrate and the support substrate are temporarily adhered to each other by the adhesion layer and the release agent layer to be suitably releasable, and thus, for example, when the support substrate has light transmissivity, the semiconductor substrate and the support substrate can be easily separated from each other by irradiating the release agent layer with light from the support substrate side of the laminate. Usually, release is performed after the semiconductor substrate of the laminate is processed.

### <Fourth Embodiment>

The method for producing a processed electronic device layer of the present invention includes the following step 5B and the following step 6B.

Here, the step 5B is a step of processing the electronic device layer in the laminate described in the section of <Second Embodiment> above.

In addition, the step 6B is a step of separating the electronic device layer processed in the step 5B and the support substrate.

Examples of the processing performed on the electronic device layer in the step 5B include a grinding step and a wiring layer forming step.

### <<Grinding Step>>

The grinding step is a step of grinding the resin part of the layer of the sealing resin 25 in the electronic device layer 26 such that a part of the semiconductor chip substrate 21 is exposed after the sealing step.

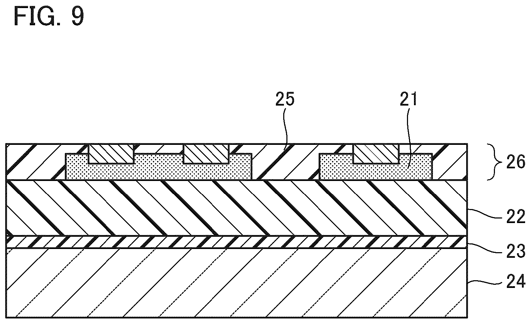

For example, as illustrated in Fig. 9, the sealing resin part is ground by scraping the layer of the sealing resin 25 to a thickness substantially equal to that of the semiconductor chip substrate 21.

### <<Wiring Layer Forming Step>>

The wiring layer forming step is a step of forming a wiring layer on the exposed semiconductor chip substrate 21 after the grinding step.

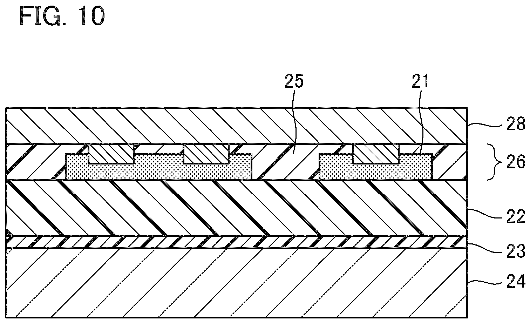

In Fig. 10, a wiring layer 28 is formed on the electronic device layer 26 including the semiconductor chip substrate 21 and the layer of the sealing resin 25.

The wiring layer 28 is also called a redistribution layer (RDL), is a thin-film wiring body constituting wiring connected to a substrate, and may have a single-layer or multi-layer structure. The wiring layer may be one in which wiring is formed by a conductor (for example, metals such as aluminum, copper, titanium, nickel, gold, and silver, and alloys such as silver-tin alloys) between dielectrics (photosensitive resin such as silicon oxide (SiO_{X}) and photosensitive epoxy), but is not limited thereto.

Examples of the method for forming the wiring layer 28 include the following methods.

First, a dielectric layer of silicon oxide (SiO_{X}), a photosensitive resin, or the like is formed on the layer of the sealing resin 25. The dielectric layer made of silicon oxide can be formed by, for example, a sputtering method, a vacuum vapor deposition method, or the like. The dielectric layer made of a photosensitive resin can be formed by coating the layer of the sealing resin 25 with a photosensitive resin by a method such as spin coating, dipping, roller blade, spray coating, or slit coating.

Subsequently, wiring is formed on the dielectric layer with a conductor such as metal. As a method for forming the wiring, for example, a known semiconductor process method such as lithography processing such as photolithography (registry lithography) or etching processing can be used. Examples of such lithography processing include lithography processing using a positive resist material and lithography processing using a negative resist material.

In the method for producing a laminate according to a fourth embodiment, a bump can be further formed on the wiring layer 28 or an element can be mounted. The element can be mounted on the wiring layer 28 using, for example, a chip mounter or the like.

The laminate according to the fourth embodiment may be a laminate prepared in a process based on a fan-out type technology in which a terminal provided on a semiconductor chip substrate is mounted on a wiring layer extending outside a chip area.

In the step 6B, examples of the method for separating (releasing) the electronic device layer from the support substrate include, but are not limited to, mechanical releasing with equipment having a sharp portion, releasing between the support and the electronic device layer, and the like after the release agent layer is irradiated with light.

By irradiating the release agent layer with light from the support substrate side, the release agent layer is altered (for example, separation or decomposition of the release agent layer) as described above, and thereafter, for example, one of the substrates is pulled up, and the electronic device layer and the support substrate can be easily separated from each other.

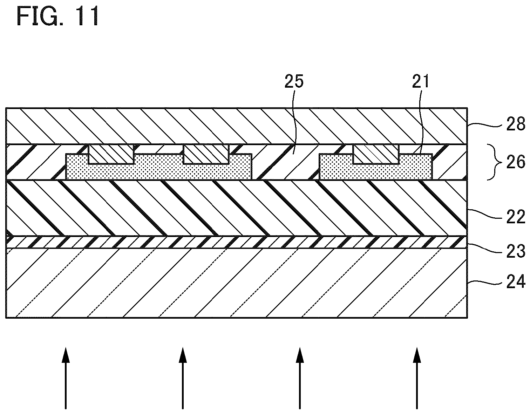

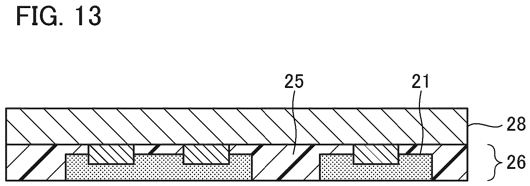

Figs. 11 to 12 are schematic cross-sectional views for explaining a method for separating the laminate, and Fig. 13 is a schematic cross-sectional view for explaining a method for cleaning the laminate after the separation. An embodiment of the method for producing the semiconductor package (electronic component) can be described with reference to Figs. 11 to 13.

As shown in Fig. 11, the step of separating the laminate is a step of separating the electronic device layer 26 and the support substrate 24 by irradiating the release agent layer 23 with light (arrow) through the support substrate 24 to alter the release agent layer 23.

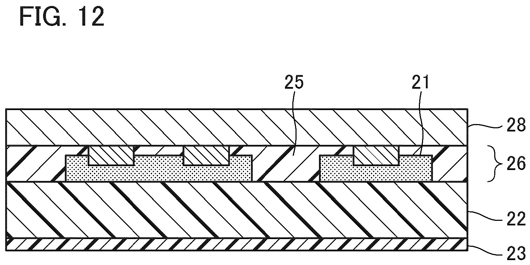

After irradiating the release agent layer 23 with light (arrow) to alter the release agent layer 23, the support substrate 24 is separated from the electronic device layer 26 as shown in Fig. 12.

The irradiation conditions, irradiation methods, and the like of light irradiation to the adhesion layer are as described in the section of <Third Embodiment> above.

The substrate can be cleaned by spraying the cleaning agent composition onto the surface of at least one of the separated electronic device layer and support substrate, or immersing the separated electronic device layer or support substrate in the cleaning agent composition.

In addition, the surface of the processed electronic device layer or the like may be cleaned using a removal tape or the like.

For example, in Fig. 12, the adhesion layer 22 and the release agent layer 23 are attached to the electronic device layer 26 after the separation step, but the adhesion layer 22 and the release agent layer 23 can be removed by decomposing the adhesion layer 22 and the release agent layer 23 using a cleaning agent composition such as acid or alkali. By removing the release agent layer and the adhesion layer, a processed electronic device layer (electronic component) as shown in Fig. 13 can be suitably obtained.

The constituent elements and method elements related to the above-described steps of the method for producing a processed electronic device layer of the present invention may be variously changed without departing from the gist of the present invention.

The method for producing a processed electronic device layer of the present invention may include steps other than the above-described steps.

In the laminate of the present invention, the electronic device layer and the support substrate are temporarily adhered to each other by the adhesion layer to be suitably releasable, and thus, for example, when the support substrate has light transmissivity, the electronic device layer and the support substrate can be easily separated from each other by irradiating the release agent layer with light from the support substrate side of the laminate. Usually, release is performed after the electronic device layers of the laminate are processed.

### Examples

Hereinafter, the present invention will be described more specifically with reference to Examples, but the present invention is not limited to the following Examples. The apparatus used is as follows.

### [Apparatus]

(1) Stirrer: rotation and revolution mixer ARE-500 manufactured by Thinky Corporation
(2) Viscometer: rotation viscometer TVE-22H manufactured by Toki Sangyo Co., Ltd.
(3) Transmittance measuring apparatus: UV3600 Plus manufactured by Shimadzu Corporation
(4) Vacuum bonding apparatus: manufactured by SUSS MicroTec, manual bonder
(5) Laser irradiation device: NC-LD300 EXC manufactured by Optec Inc

### [Preparation Example 1]

In a 100 mL glass bottle, 2.5 g of tannic acid (manufactured by KANTO CHEMICAL CO., INC.) and 47.5 g of pure water were put, and stirred to prepare the composition (1).

### [Preparation Example 2]

In a 100 mL glass bottle, 2.5 g of tannic acid (manufactured by KANTO CHEMICAL CO., INC.), 0.25 g of Acid Red 18 (manufactured by Tokyo Chemical Industry Co., Ltd.), and 47.25 g of pure water were put, and stirred to prepare the composition (2).

### [Preparation Example 3]

In a 100 mL glass bottle, 2.5 g of tannic acid (manufactured by KANTO CHEMICAL CO., INC.), 0.25 g of Chlorantine Fast Red 5B (manufactured by Tokyo Chemical Industry Co., Ltd.), and 47.25 g of pure water were put, and stirred to prepare the composition (3).

### [Preparation Example 4]

In a 100 mL glass bottle, 2.5 g of tannic acid (manufactured by KANTO CHEMICAL CO., INC.), 0.25 g of Chromium Pure Blue BX (manufactured by Tokyo Chemical Industry Co., Ltd.), and 47.25 g of pure water were put, and stirred to prepare the composition (4).

### [Preparation Example 5]

An adhesive composition (A) used for the bonding test of Example 2 below was prepared as follows.

In a 600 mL stirring vessel dedicated to a stirrer, 80 g of an MQ resin (manufactured by Wacker Chemie AG) containing a polysiloxane and a vinyl group as the polyorganosiloxane (a1), 2.52 g of a SiH group-containing linear polydimethylsiloxane (manufactured by Wacker Chemie AG) having a viscosity of 100 mPa·s as the polyorganosiloxane (a2), 5.89 g of a SiH group-containing linear polydimethylsiloxane (manufactured by Wacker Chemie AG) having a viscosity of 70 mPa·s as the polyorganosiloxane (a2), and 0.22 g of 1-ethynylcyclohexanol (manufactured by Wacker Chemie AG) as the polymerization inhibitor (A3) were put, and stirred with the stirrer for 5 minutes.

0.147 g of a platinum catalyst (manufactured by Wacker Chemie AG) as the platinum group metal-based catalyst (A2) and 5.81 g of a vinyl group-containing linear polydimethylsiloxane (manufactured by Wacker Chemie AG) having a viscosity of 1000 mPa·s as the polyorganosiloxane (a1) were stirred with a stirrer for 5 minutes to obtain a mixture, and 3.96 g of the mixture was added and stirred with a stirrer for 5 minutes.

Finally, the obtained mixture was filtered through a nylon filter 300 mesh to obtain an adhesive composition (A). The viscosity of the adhesive measured with a viscometer was 10,000 mPa·s.

In order to confirm a wavelength region in which light can be absorbed when the release agent layer formed using the release agent composition for light irradiation release of the present invention is irradiated with a laser beam, transmittance to any wavelength was measured as described in the following Example 1.

### [Example 1] Measurement of Transmittance

Compositions (1) to (4) obtained in Preparation Examples 1 to 4 were applied onto a quartz substrate using a spin coater, and heated on a hot plate at 250°C for 5 minutes to form a thin film having a thickness of 200 nm.

The obtained quartz substrate coated with the release agent composition and the quartz substrate to which nothing was applied as a reference were fixed on a stage in the apparatus, and the transmittance of the layer applied onto the quartz substrate was measured at intervals of 0.5 nm in the wavelength region of 190 to 800 nm. The results of transmittance at 308, 355, and 532 nm are shown in Table 1 below.

In order to confirm whether or not the release agent layer formed using the release agent composition for light irradiation release of the present invention can be easily released by laser irradiation, a laminate described in the following Example 2 was prepared, and a laser irradiation test described in the following Example 3 was performed.

### [Example 2] Preparation of Laminate

The adhesive composition (A) was applied to a 100 mm silicon wafer (thickness: 500 µm) as a device-side wafer with a spin coater to form an adhesive composition layer (A) having a thickness of 30 µm. A 100 mm glass wafer (EAGLE-XG, manufactured by Corning Incorporated, thickness: 500 µm) was prepared as a wafer (support) on the carrier side, and the compositions (1) to (4) were applied by a spin coater and heated on a 250°C hot plate for 5 minutes to form composition layers (1) to (4) to a thickness of 200 nm. The adhesive composition layer (A) and the composition layers (1) to (4) were sandwiched and bonded together in a vacuum bonding apparatus to prepare a laminate. Thereafter, the device-side wafer was heated on a hot plate at 200°C for 10 minutes to cure each composition layer, thereby obtaining the laminates (1) to (4).

Laminates using the composition layers (1) to (4) correspond to the laminates (1) to (4), respectively.

### [Example 3] Laser Irradiation Test

Using a laser irradiation device, the obtained laminates (1) to (4) were irradiated with a laser from the glass wafer side at an output of 250 mJ/cm², and it was confirmed whether the glass wafer could be released. After the laser irradiation, the glass wafer was lifted with tweezers, and the case where the glass wafer could be easily released was denoted as "∘", and the case where the glass wafer could not be released was denoted as "×".

The test results of Example 3 are shown in Table 1 below.

**[Table 1]**

| Composition layer | Transmittance at 308 nm [Example 1] | Transmittance at 355 nm [Example 1] | Transmittance at 532 nm [Example 1] | Result of laser irradiation test [Example 3] |
|---|---|---|---|---|
| 1 | 16.5 | 92.2 | 96.5 | ○ |
| 2 | 7.1 | 67.9 | 75.7 | ○ |
| 3 | 23.2 | 61.1 | 80.1 | ○ |
| 4 | 16.9 | 58.3 | 70.9 | ○ |

From the above Examples, it was confirmed that the composition layers (1) to (4) formed using the release agent composition for light irradiation release defined in the present invention had good laser releasability.

Further, in the composition layers (2) to (4), the transmittance on the high wavelength side tended to decrease as a whole, and it was confirmed that the light absorption wavelength region of the release agent composition could be widened by mixing the water-soluble dye.

The release agent composition for light irradiation release defined in the present invention does not require an organic solvent, and furthermore, in a laminate which can firmly adhere a support substrate and the semiconductor substrate or the electronic device layer during processing of the semiconductor substrate or the electronic device layer and which can easily separate the support substrate and the semiconductor substrate or the electronic device layer from each other by light irradiation after the substrate processing, a release agent layer to be used in the laminate can be effectively formed.

### Reference Signs List

- 1: Semiconductor substrate
- 2: Adhesion layer
- 3: Release agent layer
- 4: Support substrate
- 5: Release agent layer having adhesive performance
- 21: Semiconductor chip substrate
- 22: Adhesion layer
- 23: Release agent layer
- 24: Support substrate
- 25: Sealing resin
- 26: Electronic device layer
- 27: Release agent layer having adhesive performance
- 28: Wiring layer

## Claims

1. A release agent composition for light irradiation release for forming a release agent layer of a laminate
which includes
a semiconductor substrate or an electronic device layer,
a light-transmissive support substrate, and
a release agent layer provided between the semiconductor substrate or the electronic device layer and the support substrate,
in which the electronic device layer includes a plurality of semiconductor chip substrates and a sealing resin disposed between the semiconductor chip substrates, and
which is used for releasing the semiconductor substrate or the electronic device layer from the support substrate after the release agent layer absorbs light irradiated from the support substrate side, wherein
the release agent composition contains a light-absorbing compound that contributes to making the semiconductor substrate or the electronic device layer and the support substrate easily released by absorbing the light, and a solvent, and
the solvent contains water.

2. The release agent composition according to claim 1, wherein a content of the water is 50% by mass or more with respect to the solvent in the release agent composition.

3. The release agent composition according to claim 2, wherein a content of the water is 98% by mass or more with respect to the solvent in the release agent composition.

4. The release agent composition according to claim 1, wherein when an absorption spectrum of the light-absorbing compound is measured in a range of 250 nm to 800 nm, the absorption spectrum of the light-absorbing compound has a maximum absorbance between 250 nm and 350 nm, the highest value being within a range of 250 nm to 800 nm.

5. The release agent composition according to claim 4, wherein the light-absorbing compound is a polyphenol-based compound.

6. The release agent composition according to claim 5, wherein the polyphenol-based compound is a compound selected from a group consisting of condensed tannin obtained by polymerizing a compound having a flavanol skeleton, hydrolyzable tannin obtained by ester-bonding an aromatic compound of gallic acid or ellagic acid to a sugar, and a flavonoid derived from a compound having a flavanone skeleton structure.

7. The release agent composition according to claim 6, wherein the hydrolyzable tannin is tannic acid represented by the following Formula (9).

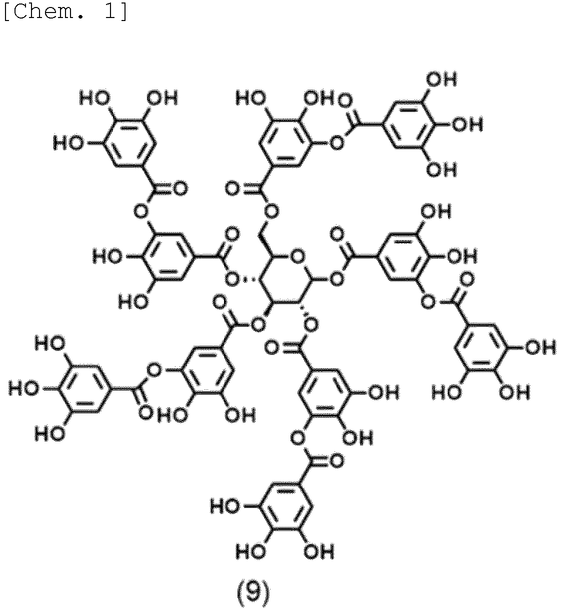

8. The release agent composition according to any one of claims 1 to 7, wherein the release agent composition further contains a water-soluble dye.
